(19) Europäisches Patentamt
European Patent Office
Office européen des brevets

(11) **EP 3 438 229 B1**

(12) **EUROPEAN PATENT SPECIFICATION**

(45) Date of publication and mention of the grant of the patent:
**10.03.2021 Bulletin 2021/10**

(51) Int Cl.:
***C09K 11/79*** *(2006.01)*  ***C09K 11/08*** *(2006.01)*
***H01L 33/50*** *(2010.01)*

(21) Application number: **17775146.8**

(22) Date of filing: **28.03.2017**

(86) International application number:
**PCT/JP2017/012760**

(87) International publication number:
**WO 2017/170609 (05.10.2017 Gazette 2017/40)**

(54) **FLUORESCENT BODY, LIGHT-EMITTING DEVICE, ILLUMINATING APPARATUS, AND IMAGE DISPLAY APPARATUS**

FLUORESZIERENDER KÖRPER, LICHTEMITTIERENDE VORRICHTUNG, BELEUCHTUNGSVORRICHTUNG UND BILDANZEIGEVORRICHTUNG

CORPS FLUORESCENT, DISPOSITIF D'ÉMISSION DE LUMIÈRE, APPAREIL D'ÉCLAIRAGE, ET APPAREIL D'AFFICHAGE D'IMAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2016 JP 2016066764**
**26.07.2016 JP 2016146734**

(43) Date of publication of application:
**06.02.2019 Bulletin 2019/06**

(73) Proprietor: **Mitsubishi Chemical Corporation Tokyo 100-8251 (JP)**

(72) Inventors:
• **INATA, Yuhei**
**Odawara-shi**
**Kanagawa 250-0862 (JP)**
• **KOMURO, Naoyuki**
**Odawara-shi**
**Kanagawa 250-0862 (JP)**
• **HORIBE, Kentarou**
**Odawara-shi**
**Kanagawa 250-0862 (JP)**

(74) Representative: **Hoffmann Eitle Patent- und Rechtsanwälte PartmbB Arabellastraße 30 81925 München (DE)**

(56) References cited:
**WO-A1-2010/114061**  **WO-A1-2013/073598**
**WO-A1-2014/123198**  **JP-A- 2009 035 673**
**JP-A- 2016 028 124**  **JP-A- 2016 028 124**
**JP-A- 2017 041 629**  **US-A1- 2013 234 588**
**US-A1- 2014 319 568**  **US-A1- 2014 321 099**
**US-A1- 2016 009 991**

**Description**

Technical Field

The present invention relates to a phosphor, a light emitting device, an illumination apparatus, and an image display apparatus.

Background Art

In recent years, in response to trends in energy conservation, there have been increasing demands for illumination or backlight using a light emitting device (LED). The LED used herein is a white light emitting LED in which a phosphor is disposed on an LED chip which emits blue light or light having a near-ultraviolet wavelength. For this type of white light emitting LED, a light emitting LED using an yttrium aluminum garnet (YAG) phosphor, which is disposed on a blue light LED chip and emits yellow light as excitation light using blue light from the blue light LED chip, is often used.

However, in a case where a YAG phosphor is used under high power, there is a problem that as the temperature of the phosphors increases, the luminance decreases, so-called temperature quenching is large. Particularly, in a long wavelength light emitting range of a peak wavelength of 540 nm or more, there is a problem that the temperature properties are more remarkably deteriorated.

Further, in order for the emission color of the YAG phosphor to have a wavelength of 550 nm or more, it is necessary to adjust constitutional elements of a matrix by adding gadolinium, terbium, and the like thereto, and there is a case where temperature properties are significantly deteriorated.

In addition, in order to obtain a better color reproduction range or better color rendering properties, when light is excited by near ultraviolet rays (typically, a range including purple of about 350 to 420 nm as a term for the blue excitation is referred to as near-ultraviolet rays), there is a case where the luminance significantly decreases.

In consideration of these circumstances, intensive studies on a nitride phosphor which emits yellow light have been conducted. As the phosphor, for example, $(La,Y)_3Si_6N_{11}$ phosphors disclosed in Patent Literatures 1 to 3 (including a case where lanthanum or yttrium is replaced with other metals; hereinafter, this kind of phosphor is sometimes referred to as "LYSN phosphor") and the like have been developed.

On the other hand, as described above, an LED is widely known as a semiconductor light emitting device or a semiconductor light source that can emit light having a peak wavelength in a specific range of an optical spectrum. Typically, LEDs are used as light sources for illuminators, signs, vehicle headlamps, and displays.

As a light emitting device using an LED and a phosphor, a light emitting device emitting white light in which an LED chip which emits blue light and an yttrium aluminum garnet (YAG) phosphor which converts blue light into yellow are combined is known. The YAG phosphor is disposed around an LED chip as a wavelength conversion light emitting layer dispersed in an epoxy resin or a silicone resin.

In addition to the wavelength conversion light emitting layer dispersed in the resin, a ceramic layer including a phosphor or a wavelength conversion light emitting layer (light emitting ceramic layer) in which a phosphor is dispersed in ceramic and which is formed of only an inorganic material is described as an example (Patent Literature 4).

On the other hand, in recent years, a large number of new substances related to nitrides including ternary or higher order elements have been produced, and particularly phosphor materials having excellent properties in multinary nitrides or oxynitrides based on silicon nitride have been developed and used for wavelength conversion light emitting layers.

It is known that these phosphor materials are excited by blue light LEDs or near ultraviolet LEDs to emit yellow light to red light, and exhibit high luminance and high conversion efficiency, and in addition, excellent temperature dependence of emission efficiency, in comparison with oxide-based phosphors.

Conventionally, a wavelength conversion light emitting layer dispersed in an organic binder such as an epoxy resin or a silicone resin, has had insufficient durability, heat resistance, and emission intensity. Therefore, in order to obtain a wavelength conversion light emitting layer having further excellent durability and heat resistance, as described as an example in Patent Literature 4, a method of preparing a wavelength conversion light emitting layer (light emitting ceramic layer) formed of only an inorganic material has been researched.

In Patent Literature 5, a phosphor ceramic in which YAG:Ce phosphor particles are dispersed in an inorganic binder formed of any one of calcium fluoride, strontium fluoride, and lanthanum fluoride, or formed of calcium fluoride and strontium fluoride is described as an example.

In Patent Literature 6, a wavelength conversion light emitting layer formed only of an inorganic material is prepared with a combination of a $Y_3(Al,Ga)_5O_{12}$:Ce oxide phosphor, a $Lu_3Al_5O_{12}$:Ce (LuAG) oxide phosphor, and a $CaSiAlN_3$:Eu (CASN) nitride phosphor by melting a glass powder having a glass transition point of 200°C or higher by using a discharge plasma sintering method.

Patent Literature 7 relates to a phosphor represented by the general formula $La_vY_wGd_xCe_ySi_6N_{8+z}$ wherein v, w, x, y and z satisfy $2.0 \leq v \leq 3.0$, $0.01 \leq w \leq 0.5$, $0.01 \leq x \leq 0.5$, $0 < y \leq 1.0$ and $2.0 \leq z \leq 4.0$).

Patent Literature 8 relates to a phosphor represented by the general formula $M_x Ce_y Pr_z Si_6 N_{8+w}$. M is at least one element selected from the group consisting of La, Y, Tb and Lu. And x, y, z and w satisfy $2.0 < x < 3.5$, $0 < y < 1.0$, $0 < z < 0.05$ and $2.0 < w < 4.0$.

Background Art

Patent Literature

    [Patent Literature 1] WO2008/132954
    [Patent Literature 2] WO2010/114061
    [Patent Literature 3] WO2014/123198
    [Patent Literature 4] JP-T-2008-502131
    [Patent Literature 5] WO2009/154193
    [Patent Literature 6] JP-A-2009-91546
    [Patent Literature 7] JP 2016 028124 A
    [Patent Literature 8] US 2014/319568 A1

Summary of Invention

Technical Problem to be Solved by Invention

The LYSN phosphors disclosed in Patent Literatures 1 to 3 have a little decrease in emission luminance even in a case where the temperature increases, and sufficient emission is obtained even with excitation by near-ultraviolet rays. However, for example, in a case where an illumination apparatus is produced by using an LYSN phosphor, it is necessary to use a red phosphor to compensate for red color. Thus, LYSN phosphors having an emission peak in a longer wavelength range (546 to 570 nm) are required. It is further required for these phosphors to have higher emission luminance and a higher temperature maintenance rate.

In addition, in Patent Literature 4, an aluminum garnet phosphor is used as the light emitting ceramic layer. In this case, a YAG powder is prepared from $Y_2O_3$, $Al_2O_3$ (99.999%), and $CeO_2$, and a molded product formed of only the YAG powder is obtained and then baked at 1300°C, whereby a YAG sintered phosphor is obtained and used as the light emitting ceramic layer. In the light emitting ceramic layer, no inorganic binder is used, and the sintered composite is formed only of a YAG oxide-based phosphor. Therefore, there has been demanded a sintered phosphor of a nitride phosphor exhibiting high luminance, high conversion efficacy, and in addition, excellent temperature dependence of emission efficiency.

As described as an example in Patent Literature 5, there has been a problem that both the ceramic composites of a YAG oxide phosphor phase and a fluoride matrix phase have low internal quantum efficiency values of 55% or less.

In Patent Literature 6, the glass powder is melted, whereby the combination of the YAG oxide phosphor or the LuAG oxide phosphor with the CASN nitride phosphor is dispersed in the glass to prepare the wavelength conversion light emitting layer. However, since an inorganic binder is the glass, there is a problem that in spite of heat resistance, a thermal conductivity is as low as 2 to 3 W/mK; in addition, since heat dissipation is poor, the temperature of a phosphor is increased, thereby decreasing the luminance (deteriorating the phosphor).

In consideration of the above circumstance, the present invention provides an LYSN phosphor having an emission peak in a long wavelength range (546 to 570 nm) (hereinafter, sometimes referred to as "long wavelength LYSN phosphor"). Further, the present invention provides an LYSN phosphor having high emission luminance and a high temperature maintenance rate. In addition, the present invention provides a high quality light emitting device with a low color temperature without using a red phosphor, a high quality illumination apparatus, and a high quality image display apparatus.

Means for Solving Problems

As a result of intensive investigations conducted by the present inventors, it has been found that an LYSN phosphor having an emission peak wavelength on a long wavelength side and having high emission luminance has a crystal lattice size smaller than that of a conventional LYSN phosphor.

Here, the present inventors have found that a long wavelength LYSN phosphor having high emission luminance can be defined by a lattice constant, which is one index of the size of the crystal lattice, and a ratio of a specific constitutional element and thus have accomplished the present invention as defined in the claims, including a phosphor, a light emitting device, an illumination apparatus, an image display apparatus and a method of producing a phosphor.

Effects of Invention

According to the present invention, it is possible to provide an LYSN phosphor having an emission peak in a long wavelength range (546 to 570 nm). Further, according to the present invention, it is possible to provide an LYSN phosphor having high emission luminance and a high temperature maintenance rate. In addition, according to the present invention, it is also possible to provide a high quality light emitting device having high color rendering properties without using a red phosphor, a high quality illumination apparatus, and a high quality image display apparatus.

Brief Description of Drawings

[Fig. 1] Fig. 1 is a graph showing emission spectra of phosphors obtained in Example 8 and Comparative Example 1.
[Fig. 2] Fig. 2 is a graph showing XRD patterns of Example 5 and Comparative Examples 4 and 5.
[Fig. 3] Fig. 3 is a schematic view showing a configuration example of a semiconductor light emitting device according to an embodiment of the present invention.
[Fig. 4] Fig. 4 is a schematic view showing a configuration example of the semiconductor light emitting device according to the embodiment of the present invention.
[Fig. 5] Fig. 5 is a graph showing a powder X-ray diffraction pattern of a phosphor used in Example 15.
[Fig. 6] Fig. 6 is a graph showing a powder X-ray diffraction pattern of a phosphor used in Example 16.
[Fig. 7] Fig. 7 is a graph showing emission spectra of sintered phosphors of Example 15 and Example 16 by LED excitation.
[Fig. 8] Fig. 8 is a graph showing a simulation result of an emission spectrum of a sintered phosphor of Example 17 by LED excitation.
[Fig. 9] Fig. 9 is a graph showing a simulation result of an emission spectrum of a sintered phosphor of Example 18 by LED excitation.
[Fig. 10] Fig. 10 is a graph showing simulation results of emission spectra of sintered phosphors of Examples 19 to 22 by LED excitation.
[Fig. 11] Fig. 11 is a graph showing simulation results of emission spectra of sintered phosphors of Examples 23 to 26 by LED excitation.

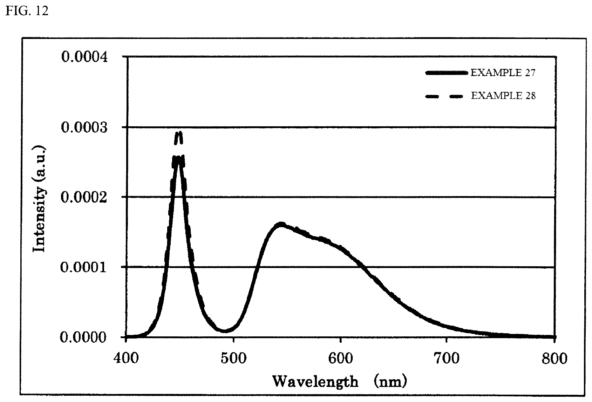

[Fig. 12] Fig. 12 is a graph showing emission spectra of sintered phosphors of Examples 27 and 28 by LED excitation.

Description of Embodiments

Each composition formula of the phosphors in this specification is punctuated by a comma (,). Enumerations of a plurality of elements separated by commas (,) denote that one or two or more of the listed elements may be contained in any combination and composition.
Hereinafter, embodiments of a phosphor, a light emitting device, an illumination apparatus, and an image display apparatus according to the present invention will be described in detail. However, the present invention is not limited to the following embodiments and can be variously modified within a scope thereof.

{Phosphor}

The phosphor of the present invention includes a tetragonal crystal phase,
the crystal phase includes M element, La, A element, Si, and N, has a composition represented by Formula (1) defined below, and satisfies the following formulae [I] and [II], and
a lattice constant a is 1.0104 nm (10.104 Å) or more and 1.0154 nm (10.154 Å) or less.

$$0.10 \leq x/(w + x) \leq 0.50 \quad [\text{I}]$$

$$2.80 \leq w + x + z \leq 3.20 \quad [\text{II}]$$

(wherein M element represents one or more of elements selected from Eu, Ce, Mn, Fe and Pr (hereinafter also referred to as "activation elements"); and

A element represents one or more of elements selected from rare earth elements other than La and the activation elements.

In formulae [I] and [II],

w represents a content of La element when a molar ratio of Si is 6;

x represents a content of A element when a molar ratio of Si is 6; and

z represents a content of M element when a molar ratio of Si is 6.)

In the present specification, the content of each element when the molar ratio of Si is 6 is expressed by molar ratio.

The phosphor of the present invention is obtained by preparing raw materials such that the ratio of each element included in the raw materials satisfies the following formulae [III] and [IV] and firing the raw materials.

$$0.1 \leq x2/(w2 + x2) \leq 0.5 \quad [\text{III}]$$

$$2.85 \leq w2 \leq 3.2 \quad [\text{IV}]$$

(wherein M element represents one or more of elements selected from activation elements; and

A element represents one or more of elements selected from rare earth elements other than La and the activation elements.

In formulae [III] and [IV],

w2 represents a preparation amount of La element when a molar ratio of Si is 6; and

x2 represents a preparation amount of A element when a molar ratio of Si is 6.)

In the present specification, the preparation amount of each element when the molar ratio of Si is 6, namely, the composition of metal elements included in the raw materials is expressed by molar ratio.

M element represents one or more of elements selected from activation elements. Activation elements are europium (Eu), cerium (Ce), manganese (Mn), iron (Fe), and praseodymium (Pr).

For M element, one of element may be used alone or two or more different elements may be contained. Among these, M element preferably contains Eu or Ce; more preferably contains Ce at a ratio of 80% by mol or more with respect to all activation elements; further more preferably contains Ce at a ratio of 95% by mol or more with respect to all activation elements; and most preferably contain Ce alone.

La represents lanthanum.

A element represents one or more of elements selected from rare earth elements other than La and the activation elements. Examples of A element include yttrium (Y), gadolinium (Gd), neodymium (Nd), samarium (Sm), terbium (Tb), dysprosium (Dy), holmium (Ho), erbium (Er), thulium (Tm), lutetium (Lu), and ytterbium (Yb). Among these, A element preferably contains Y from the viewpoint of easily obtaining the effects in the present invention.

In addition, for A element, one element may be used alone or two or more different elements may be contained.

Si represents silicon. Si may be partially substituted by another quadrivalent element, such as germanium (Ge), tin (Sn), titanium (Ti), zirconium (Zr) and hafnium (Hf).

N represents a nitrogen element. N may be partially substituted by another element, such as an oxygen atom (O), or a halogen atom (such as fluorine (F), chlorine (Cl), bromine (Br), or iodine (I)).

Oxygen may be mixed as an impurity in the raw material or may be introduced during such production processes as a pulverization step and a nitrization step, which cannot be avoided for the phosphor of the present invention.

In addition, halogen atoms may be mixed as an impurity in the raw material, or may be introduced during such production processes as a pulverization step and a nitrization step, and is particularly possible to be contained in the phosphor when halide is used as a flux.

The phosphor of the present invention satisfies the formulae [I] and [II].

In the Expression [I], when the molar ratio of Si is 6, a value of x/(w + x) is preferably 0.11 or more and 0.45 or less, and more preferably 0.12 or more and 0.40 or less. In the Expression [II], when the molar ratio of Si is 6, a value of w + x + z is preferably 2.85 or more and 3.15 or less and more preferably 2.90 or more and 3.10 or less.

The crystal phase of the phosphor of the present invention satisfies the formulae [I] and [II] so that the emission peak wavelength of the phosphor is on the long wavelength side. Therefore, even in a case where the phosphor of the present invention alone and a blue light LED chip are combined, a color temperature of about 3000 to 5000 K can be achieved and this case is preferable. In addition, this case is preferable from the viewpoint that a different phase derived from A element is not easily generated and a phosphor having higher crystallinity is formed.

The phosphor of the present invention is obtained by preparing raw materials such that the ratio of each element included in the raw materials satisfies the formulae [III] and [IV], and firing the raw materials. In the Expression [III], when the molar ratio of Si is 6, a value of x2/(w2 + x2) satisfies $0.1 \leq x2/(w2 + x2) \leq 0.5$. The lower limit thereof is preferably 0.105 and more preferably 0.11, and the upper limit thereof is preferably 0.4 and more preferably 0.3.

In the Expression [IV], when the molar ratio of Si is 6, a value of w2 satisfies $2.85 \leq w2 \leq 3.2$. The lower limit thereof is preferably 2.875 and the upper limit thereof is preferably 3.15.

[Regarding Formula (1)]

The phosphor of the present invention includes a crystal phase having a composition represented by the following formula (1).

$$La_wA_xSi_6N_yM_z \qquad (1)$$

(In the formula (1), M element represents one or more elements selected from activation elements; and
A element represents one or more elements selected from rare earth elements other than La and the activation elements, and
w, x, y, and z each independently represents values satisfying the following formulae,
w satisfies $1.50 \leq w \leq 2.7$;
x satisfies $0.2 \leq x \leq 1.5$;
y satisfies $8.0 \leq y \leq 14.0$; and
z satisfies $0.05 \leq z \leq 1.0$.)

In the formula (1), M element and A element have the same ranges as the ranges of the elements described above and the ranges and preferable aspects thereof are also the same.

In the formula (1), w represents a content of La and is the same as w in the formulae [I] and [II]. The range and preferable aspect thereof are also the same.

In the formula (1), x has the same meaning as x in the formulae [I] and [II] and represents a content of A element, and the range thereof is $0.2 \leq x \leq 1.5$. The lower limit is preferably 0.25 and more preferably 0.30, and the upper limit is preferably 1.2 and more preferably 1.0.

In the formula (1), y represents a content of N, and the range thereof is $8.0 \leq y \leq 14.0$. The lower limit is preferably 8.5 and more preferably 8.0, and the upper limit is preferably 13.5 and more preferably 13.0.

In the formula (1), z represents a content of M element and the range thereof is $0.05 \leq z \leq 1.00$. The lower limit is preferably 0.10 and more preferably 0.20, and the upper limit is preferably 0.95 and more preferably 0.90.

The content of each element described above is expressed by molar ratio.

[Crystal Structure, Crystal System, and Space Group of Phosphor of Present Invention]

The phosphor of the present invention adopts a tetragonal crystal structure reported as a composition formula of $La_3Si_6N_{11}$, and La, A element, and M element are introduced into the La position in the composition formula. Crystals are formed in which the lattice constants and the atomic coordinates are different while the basic crystal structure is being maintained by such element substitution.

Although the space group of the phosphor of the present invention is not particularly limited as long as the average structure statistically considered in a range distinguished by using single crystal X-ray diffraction indicates the above-described length of cycle period, but preferably belongs to P4bm (100) based on "International Tables for Crystallography (Third, revised edition), Volume A SPACE-GROUP SYMMETRY".

(Lattice Constant)

According to Reference Literature 1 [Acta Crystallographica. Section E, vol. 70, i23 page (2014)], $La_3Si_6N_{11}$ is a tetragonal crystal and has a space group of P4bm, the lattice constant of an a axis (lattice constant a) thereof is 1.01988 nm (10.1988 Å), and the lattice constant of a c axis (lattice constant c) is 0.484153 nm (4.84153 Å).

The phosphor of the present invention is based on $La_3Si_6N_{11}$ and is obtained by substituting La by Y, Gd, or the like having a smaller ionic radius than La.

[Lattice Constant]

The lattice constant of the phosphor of the present invention is as follows.

The lattice constant of the a axis (lattice constant a) is a value satisfying 1.0104 nm (10.104 Å) or more and 1.0154 nm (10.154 Å) or less, the lower limit thereof is preferably 1.0109 nm (10.109 Å) and more preferably 1.0114 nm (10.114 Å), and the upper limit thereof is preferably 1.0149 nm (10.149 Å) and more preferably 1.0144 nm (10.144 Å).

In addition, the lattice constant of the b axis (lattice constant b) has the same value as the lattice constant a.

The lattice constant of the c axis (lattice constant c) is typically a value satisfying 0.4820 nm (4.820 Å) or more and 0.4860 nm (4.860 Å) or less, the lower limit thereof is preferably 0.4825 nm (4.825 Å) and more preferably 0.4830 nm (4.830 Å), and the upper limit thereof is preferably 0.4865 nm (4.865 Å) and more preferably 0.4860 nm (4.860 Å).

A case where the lattice constant a is within the above range is preferable from the viewpoint that the effects of the present invention can be satisfactorily obtained. Further, a case where the lattice constant c is within the above range is preferable from the viewpoint that the effects of the present invention can be more easily obtained. Such a phosphor exhibits excellent crystallinity since an impurity phase is prevented from being generated due to stable crystal formation. Therefore, the phosphor of the present invention is preferable since the emission luminance is favorable.

[Reason for Exhibiting Effect]

The reason for exhibiting the effect that an LYSN phosphor having an emission peak in a long wavelength range compared to a conventional LYSN phosphor by adopting the configuration of the present invention is assumed as follows.

Each A element in the present invention is an element having a smaller ionic radius than La. Therefore, by partially substituting La by A element in a predetermined amount, a distance between ions in the crystal lattice is reduced. Namely, the lattice constant of the phosphor is decreased. Accordingly, the crystal field around the activation element becomes stronger and thus the emission peak wavelength of the phosphor becomes longer.

Here, the lattice constant and the space group may be determined by a typical method. The lattice constant can be determined by performing Rietveld analysis on the X-ray diffraction or the neutron beam diffraction result, and the space group can be determined by electron beam diffraction.

{Regarding Properties of Phosphor}

[Emission Colors]

By adjusting the chemical composition or the like, the phosphor of the present invention can be excited by light in the near-ultraviolet region to the blue region at a wavelength of 300 to 460 nm, and can emit desired colors, such as greenish blue, green, yellowish green, yellow, orange and red.

[Emission Spectrum]

It is preferable that the phosphor of the present invention has the following properties in a case where the phosphor is excited by light having a wavelength of 300 nm or more and 460 nm or less and the emission spectrum is measured. In the phosphor of the present invention, the peak wavelength in the above-described emission spectrum is typically 546 nm or more and preferably 550 nm or more. The peak wavelength is also typically 570 nm or less and preferably 565 nm or less. In a case where the peak wavelength is within the above range, a good green to yellow color is emitted from the phosphor to be obtained and thus this case is preferable.

[Half Width of Emission Spectrum]

In the phosphor of the present invention, the half width of the emission peak in the above-described emission spectrum is typically 130 nm or less, preferably 125 nm or less, and more preferably 120 nm or less. The half width of the emission peak is also typically 30 nm or more, preferably 40 nm or more, and more preferably 60 nm or more.

In order to excite the phosphor of the present invention by light having a wavelength of 300 nm or more and 460 nm or less, for example, a xenon lamp can be used. In addition, in order to excite the phosphor by light having a wavelength of 400 nm, for example, a GaN-based LED can be used.

The emission spectrum of the phosphor of the present invention is measured using a 150 W xenon lamp as an excitation light source and MCPD 7000 (manufactured by Otsuka Electronics Co., Ltd.) as a spectrometer. Under the condition of excitation light at 455 nm, the emission intensity of each wavelength is measured using the spectrometer in a wavelength range of 380 nm or more and 800 nm or less to obtain the emission spectrum.

[Excitation Wavelength]

The phosphor of the present invention has an excitation peak in a wavelength range that is typically 350 nm or more, preferably 360 nm or more, and more preferably 370 nm or more, and is typically 480 nm or less, preferably 470 nm or less, and more preferably 460 nm. Namely, this phosphor is excited by light in a near-ultraviolet to blue region.

{Method of Producing Phosphor of Present Invention}

A method of producing the phosphor of the present invention is not particularly limited as long as the phosphor and effects of the present invention can be obtained, but for example, a method in which raw materials are prepared so as to satisfy the formulae [III] and [IV] and the raw materials are fired may be used. Preferable examples thereof include a method in which preparation amounts are adjusted such that the crystal phase of the phosphor satisfies the composition of Formula (1), and a method in which preparation amounts are adjusted such that the composition of metal elements included in the raw materials satisfies the composition represented by the following Formula (2).

$$La_{w2}A_{x2}Si_6N_{y2}M_{z2} \qquad (2)$$

(In Formula (2),

M element represents one or more elements selected from activation elements, and
A element represents one or more elements selected from rare earth elements other than La and the activation elements,
w2 is a value satisfying the Expression [IV],
x2, y2, and z2 each independently represents values satisfying following formulae,
x2 satisfies $0.2 \leq x2 \leq 1.5$;
y2 satisfies $8.0 \leq y2 \leq 14.0$; and
z2 satisfies $0.05 \leq z2 \leq 1.0$.)

In Formula (2), w2 represents a content of La element and has the same meaning as w2 in the Expression [IV]. The range and preferable aspect thereof are also the same.

In Formula (2), x2 has the same meaning as x2 in the Expression [III] and represents a content of A element, and the range thereof is $0.2 \leq x2 \leq 1.5$. The lower limit is preferably 0.25 and more preferably 0.30, and the upper limit is preferably 1.2 and more preferably 1.0.

In Formula (2), y2 represents a content of N and the range thereof is $8.0 \leq y2 \leq 14.0$. The lower limit is preferably 8.5 and more preferably 9.0, and the upper limit is preferably 13.5 and more preferably 13.0.

In Formula (2), z2 represents a content of M element and the range thereof is $0.05 \leq z2 \leq 1.00$. The lower limit is preferably 0.10 and more preferably 0.20, and the upper limit is preferably 0.95 and more preferably 0.90.

The content of each element is expressed by molar ratio.

The molar ratio of the elements in the phosphor of the present invention is (La, A element):Si:N=3:6:11 as a stoichiometric composition, and thus as the method of producing the phosphor of the present invention, more specifically, for example, a method in which La and A element are prepared as described above so as to satisfy the formulae [III] and [IV] without excessive shortage may be used. However, the present invention is not limited thereto.

[Raw Materials]

As the raw materials (La source, A source, Si source, and M source) used in the present invention, for example, La, A element, and Si, which are elements constituting the matrix of the phosphor, and if necessary, a metal including activation element M to be added to adjust the emission wavelength or the like, an alloy, or a compound thereof may be used.

Examples of compounds of the La source, A source, Si source, and M source include nitrides, oxides, hydroxides, carbonates, nitrates, sulfates, oxalates, carboxylates, and halides of each element constituting the phosphor.

The specific kind thereof may be appropriately selected from these metal compounds in consideration of reactivity to a target product or low generation amount of NOx, SOx, or the like at the time of firing. However, from the viewpoint that the phosphor of the present invention is a nitrogen-containing phosphor, it is preferable to use a nitride and/or oxynitride. Among these, it is preferable to use a nitride since the nitride also plays a role as a nitrogen source.

Specific examples of the nitrides and oxynitrides include nitrides of the elements constituting the phosphor, such as LaN, $Si_3N_4$, or CeN, and composite nitrides of the elements constituting the phosphor, such as $La_3Si_6N_{11}$ or $LaSi_3N_5$.

In addition, the matrix of the phosphor or the phosphor itself may be used as part of the raw material. Since in the matrix of the phosphor or the phosphor, the reaction for forming the matrix of the phosphor has already completed, only contribution to crystal growth is made, and the phosphor itself can be expected to have an effect of controlling the crystal diameter and the particle size in the phosphor firing.

(Mixing of Raw Materials)

In a case where an alloy for producing a phosphor is used, as long as the composition of the contained metal elements is matched with the composition represented by the Formula (2), only the alloy for producing a phosphor may be baked, or if necessary, a flux (growth assisting agent) may be mixed therein and then the mixture may be fired.

On the other hand, in a case where the alloy for producing a phosphor is not used or the composition thereof is not matched, an alloy for producing a phosphor having another composition, a metal elementary substance, a metal compound, and the like may be mixed with the alloy for producing a phosphor and prepared such that the composition of the metal elements included in the raw materials is matched with the composition represented by the Formula (2), and the mixture may be fired.

In a case of the phosphor of the present invention, the stoichiometric composition ratio of (La, A element), Si, and N is preferably 3:6:11, and thus the mixing composition is generally set to have the theoretical composition ratio. However, the raw materials are prepared such that the ratio of each element included in the raw materials satisfies the formulae [III] and [IV]. This is because, by preparing the raw material, particularly, La element in an amount relatively larger than the composition ranges of formulae [I] and [II] of the target phosphor of the present invention, a crystal phase in which the La element, A element, and M element are incorporated in appropriate amounts can be obtained and thus a long wavelength LYSN phosphor having a small amount of impurity phase and high emission luminance can be obtained.

In this case, the molar ratio of La or La and an element by which La is substituted at the La site may be changed within a range of a theoretical composition of about 1:2 to 1:1.5. The change of the compositional ratio is particularly preferable in a case where the ratio of oxygen in the raw material is high.

The phosphor raw materials may be mixed using a known method. A method in which raw materials are put into a pot with a solvent and the raw materials are mixed while pulverizing the materials with a ball, a method in which raw materials are mixed in a dry manner and are allowed to pass through a mesh, and the like can be used. In a case where the materials are dispersed and mixed in the solvent, needless to say, the solvent is removed and if necessary, dry aggregation is disintegrated. These operations are preferably performed in a nitrogen atmosphere.

In addition, in a case where the phosphor of the present invention is produced, a flux may be used. As the flux, for example, those described in Pamphlet of International Publication No. 2008/132954, Pamphlet of International Publication No. 2010/114061 and the like can be used.

[FiringStep]

The raw material mixture obtained as described above is typically charged into a container, such as a crucible or a tray, and is put in a heating furnace in which the atmosphere can be controlled. At this time, the material of the container is preferably a material of which reactivity with the metal compound is low, and for example, boron nitride, silicon nitride, carbon, aluminum nitride, molybdenum, tungsten, and the like may be used.

The temperature of the firing is preferably 1300°C or higher and 1900°C or lower and more preferably 1400°C or higher and 1700°C or lower. In the firing, in a state in which a hydrogen-containing nitrogen gas is charged or circulated, the phosphor raw material is heated, but at this time, the pressure may be any pressure of a pressure slightly lower than atmospheric pressure or atmospheric pressure. However, atmospheric pressure or higher is preferable to prevent mixing of oxygen in the atmosphere.

The heating time (holding time at the highest temperature) at the time of the firing may be time required for a reaction between the phosphor raw material and nitrogen, but is typically 1 minute or longer, preferably 10 minutes or longer, more preferably 30 minutes or longer, and even more preferably 60 minutes or longer. In a case where the heating time is shorter than 1 minute, there is a possibility that the nitriding reaction is not completed and a phosphor with high properties cannot be obtained. In addition, the upper limit of the heating time is determined from the viewpoint of production efficiency, and is typically 50 hours or shorter, preferably 40 hours or shorter, and more preferably 30 hours or shorter.

In the firing, a firing container filled with the phosphor raw material mixture is put into a heating furnace. As a firing apparatus used herein, any apparatus may be used as long as the effects of the present invention can be obtained. However, a device in which the atmosphere can be controlled is preferable and an apparatus in which the pressure can be controlled is further preferable. For example, a hot isotropic pressurizing apparatus (HIP), a resistance heated pressure vacuum heating furnace, or the like is preferable.

In addition, before heating is started, it is preferable that a gas containing nitrogen is circulated in the firing apparatus and the nitrogen-containing gas is sufficiently substituted in the system. If necessary, the inside of the system may be evacuated, and then the nitrogen-containing gas may be circulated.

As the nitrogen-containing gas used at the firing, a gas containing a nitrogen element, for example, nitrogen, ammonia, or a mixed gas of nitrogen and hydrogen, and the like may be used. In addition, only one nitrogen-containing gas may be used and two or more nitrogen-containing gases may be arbitrarily combined at any ratio and used together.

[Post treatment Step]

In the production method in the present invention, other than the above-described steps, if necessary, other steps may be performed. For example, after the above-described firing step, if necessary, a pulverization step, a washing step, a classification step, a surface treatment step, a drying step, or the like may be performed.

(Pulverization Step)

In the pulverization step, for example, a grinder such as a hammer mill, a roll mill, a ball mill, a jet mill, a ribbon blender, a V-type blender or a Henschel mixer, or grinding using a mortar and a pestle can be used.

(Washing Step)

The washing step is not particularly limited as long as the effects of the present invention are not impaired, and for example, the washing of the phosphor surface can be performed with water such as deionized water, an organic solvent such as ethanol, or an alkaline aqueous solution such as ammonia water.

In order to improve emission properties by removing the impurity phase attached to the surface of the phosphor by removing the used flux, or the like, for example, acidic aqueous solutions containing inorganic acids such as hydrochloric acid, nitric acid, sulfuric acid, aqua regia, and a mixture of hydrofluoric acid and sulfuric acid; organic acids such as acetic acid, and the like can also be used.

(Classification Step)

The classification step can be performed by using various classifiers such as a water sieve or various air stream classifiers or vibration sieves. Among these, in a case where dry classification using a nylon mesh is used, a phosphor having a volume average diameter of about 10 $\mu$m and excellent in dispersibility can be obtained. In addition, in a case where dry classification using a nylon mesh and an elutriation treatment are used in combination, it is possible to obtain a phosphor with good dispersibility with a volume median diameter of about 20 $\mu$m.

(Dry Step)

The phosphor which has been washed is dried at about 100°C to 200°C. If necessary, a dispersion treatment (for example, mesh pass or the like) to prevent dry aggregation may be performed.

(Surface Treatment Step)

In a case where a light emitting device is produced by using the phosphor of the present invention, in order to further improve weather resistance such as moisture resistance or to improve dispersibility to a resin in the phosphor containing portion of the light emitting device described later, if necessary, a surface treatment in which the surface of the phosphor is partially covered with a different substance may be performed.

{Phosphor-Containing Composition}

The phosphor of the present invention may be used being mixed with a liquid medium. Particularly, in a case where the phosphor of the present invention is used for applications such as a light emitting device, the phosphor is preferably used in the form in which the phosphor is dispersed in the liquid medium. A composition obtained by dispersing the phosphor of the present invention in the liquid medium is appropriately referred to as a "phosphor-containing composition according to the present invention".

[Phosphor]

The kind of the phosphor of the present invention contained in the phosphor-containing composition according to the present invention is not limited and the phosphor can be arbitrarily selected from the above-described phosphors. In addition, only one phosphor of the present invention to be contained in the phosphor-containing composition according to the present invention may be used or two or more phosphors may be arbitrarily combined at any ratio and used together. Further, as long as the effects of the present invention are not significantly impaired, phosphors other than the phosphor of the present invention may be contained in the phosphor-containing composition according to the present invention.

[Liquid Medium]

The liquid medium used in the phosphor-containing composition according to the present invention is not particularly limited as long as the performance of the phosphor is not diminished within a desired range. For example, as long as liquid properties are exhibited under desired use conditions, the phosphor of the present invention is suitably dispersed, and an undesirable reaction is not caused, any inorganic material and/or organic material can be used, and for example, a silicone resin, an epoxy resin, a polyimide silicone resin, and the like may be used.

[Content Ratios of Liquid Medium and Phosphor]

The content ratios of the phosphor and the liquid medium in the phosphor-containing composition according to the present invention are arbitrary as long as the effects of the embodiment are not significantly impaired. The content of the liquid medium with respect to the entire phosphor-containing composition according to the present invention is typically 50% by weight or more and preferably 75% by weight or more, and is typically 99% by weight or less and preferably 95% by weight or less.

[Other Components]

The phosphor-containing composition according to the present invention contains other components other than the phosphor and the liquid medium, as long as the effects of the present invention are not significantly impaired. In addition, only one component may be used or two or more components may be arbitrarily combined at any ratio.

{Light Emitting Device}

The light emitting device of the present invention is a light emitting device which includes a first illuminant (excitation light source) and a second illuminant which emits visible light by irradiation with light from the first illuminant, and contains, as the second illuminant, the phosphor according to the present invention. For the phosphor of the present invention, any one phosphor may be used alone, or two or more phosphors may be arbitrarily combined at any ratio and used together.

For the phosphor of the present invention, for example, a phosphor that emits fluorescence in the yellowish green to yellow color range under irradiation with light from the excitation light source is used. Specifically, in a case where the phosphor constitutes the light emitting device, a phosphor having an emission peak in a wavelength range of 546 nm to 570 nm is preferable as a yellowish green or yellow phosphor. In addition, for the excitation source, the light having an emission peak in a wavelength range of less than 420 nm may be used.

Hereafter, an embodiment of a light emitting device, where the phosphor of the present invention has an emission peak in a wavelength range of 546 nm or more and 570 nm or less, and the first illuminant has an emission peak in a wavelength range of 350 nm or more and 460 nm or less, will be described, but this embodiment is not limited to this.

In the above case, the light emitting device of the present invention can have the follow aspects, for example. Namely, an aspect in which the first illuminant having an emission peak in a wavelength range of 350 nm or more and 460 nm or less is used, and at least one phosphor having an emission peak in a wavelength range of 535 nm or more and 600 nm or less (the phosphor of the present invention) is used as the first phosphor of the second illuminant can be used.

(Yellow Phosphor)

The light emitting device of the present invention may further contain, in addition to the phosphor of the present invention, a yellow phosphor having an emission peak in a wavelength range of 546 nm or more and 570 nm or less.

As other phosphors, for example, the following phosphors can suitably used.

As a garnet-based phosphor, for example, $(Y,Gd,Lu,Tb,La)_3(Al,Ga)_5O_{12}$:(Ce,Eu,Nd),

as orthosilicate, for example, $(Ba,Sr,Ca,Mg)_2SiO_4$:(Eu,Ce), and

as a (oxy)nitride phosphor, for example, $(Ba,Ca,Mg)Si_2O_2N_2$:Eu (SION-based phosphor), $(Li,Ca)_2(Si,Al)_{12}(O,N)_{16}$:(Ce,Eu) ($\alpha$-sialon phosphor), $(Ca,Sr)AlSi_4(O,N)_7$:(Ce,Eu) (1147 phosphor), and $(La,Ca)_3(Al,Si)_6N_{11}$:Ce (LSN phosphor) may be used.

In addition, among the above phosphors, an LSN phosphor of which the phosphor specific gravity is not significantly different is preferable.

(Red Phosphor)

The light emitting device of the present invention may further contain a red phosphor. For the red phosphor, for example, the following phosphors can be suitably used.

As an Mn activating fluoride phosphor, for example, $K_2(Si,Ti)F_6:Mn$, $K_2Si_{1-x}Na_xAl_xF_6:Mn$ ($0 < x < 1$) (collectively a KSF phosphor),

as a sulfide phosphor, for example, $(Sr,Ca)S:Eu$ (CAS phosphor), $La_2O_2S:Eu$ (LOS phosphor),

as a garnet-based phosphor, for example, $(Y,Lu,Gd,Tb)_3Mg_2AlSi_2O_{12}:Ce$,

as nanoparticles, for example, CdSe, and

as a nitride or oxynitride phosphor, for example, $(Sr,Ca)AlSiN_3:Eu$ (S/CASN phosphor), $(CaAlSiN_3)_{1-x}$ $(SiO_2N_2)x:Eu$ (CASON phosphor), $(La,Ca)_3(Al,Si)_6N_{11}:Eu$ (LSN phosphor), $(Ca,Sr,Ba)_2Si_5(N,O)_8:Eu$ (258 phosphor), $(Sr,Ca)Al_{1+x}Si_{4-x}O_xN_{7-x}:Eu$ (1147 phosphor), $Mx(Si,Al)_{12}(O,N)_{16}:Eu$ (M is Ca, Sr, or the like) ($\alpha$-sialon phosphor), and $Li(Sr,Ba)Al_3N_4:Eu$ (x above is all within a range of $0 < x < 1$) may be used.

As the red phosphor, among the above phosphors, a KSF phosphor or S/CASN phosphor is preferable.

(Green Phosphor)

The light emitting device of the present invention may further contain a green phosphor. The green phosphor in the present invention is a phosphor having an emission peak in a wavelength range of 510 to 545 nm, and for example, the following phosphors can be suitably used.

As a garnet-based phosphor, for example, $(Y,Gd,Lu,Tb,La)_3(Al,Ga)_5O_{12}:(Ce,Eu,Nd)$, and $Ca_3(Sc,Mg)_2Si_3O_{12}:(Ce,Eu)$ (CSMS),

as a silicate-based phosphor, for example, $(Ba,Sr,Ca,Mg)_3SiO_{10}:(Eu,Ce)$, and $(Ba,Sr,Ca,Mg)_2SiO_4:(Ce,Eu)$ (BSS phosphor),

as an oxide phosphor, for example, $(Ca,Sr,Ba,Mg)(Sc,Zn)_2O_4:(Ce,Eu)$ (CASO phosphor),

as an (oxy)nitride phosphor, for example, $(Ba,Sr,Ca,Mg)Si_2O_2N_2:(Eu,Ce)$, $Si_{6-z}Al_zO_zN_{8-z}:(Eu,Ce)$ ($\beta$-sialon phosphor) ($0 < z \leq 1$), $(Ba,Sr,Ca,Mg,La)_3(Si,Al)_6O_{12}N_2:(Eu,Ce)$ (BSON phosphor), $(La,Ca)_3(Al,Si)_6N_{11}:Ce$ (LSN phosphor), and

as an aluminate phosphor, for example, $(Ba,Sr,Ca,Mg)_2Al_{10}O_{17}:(Eu,Mn)$ (GBAM-based phosphor) may be used.

[Configuration of Light Emitting Device]

The light emitting device of the present invention has a first illuminant (excitation light source) and uses at least the phosphor of the present invention as the second illuminant, but the rest of the configuration is not limited, and any known device configuration may be used.

An example of an embodiment of the device configuration and the light emitting device is disclosed in JP-A-2007-291352. The other embodiments of the light emitting device are a shell type, a cup type, a chip-on-board, a remote phosphor and the like.

{Applications of Light Emitting Device}

The applications of the light emitting device of the present invention is not particularly limited and can be applied to various fields in which conventional light emitting devices are used, but this light emitting device is suitably used as a light source of an illumination apparatus and image display apparatus, since the color reproduction range is wide, and the color rendering properties are high.

[Illumination Apparatus]

The illumination apparatus of the present invention is an illumination apparatus which includes the light emitting device of the invention as a light source.

In a case of applying the light emitting device of the present invention to an illumination apparatus, the above-mentioned light emitting device is appropriately integrated into a known illumination apparatus. For example, a surface emission illumination apparatus in which a large number of light emitting devices are arranged on the bottom surface of the housing case, and the like can be used.

[Image Display Apparatus]

The image display apparatus of the present invention is an image display apparatus which includes the light emitting device of the present invention as a light source. In a case where the light emitting device of the present invention is used as the light source of the image display apparatus, it is preferable to use the light emitting device together with a color filter, although a specific configuration of the image display apparatus is not particularly limited.

For example, for the image display apparatus, in a case of a color image display apparatus using color liquid crystal display elements, an image display apparatus can be formed by using the above-described light emitting devices as a backlight, and combining this backlight with optical shutters using liquid crystals and color filters having red, green and blue pixels.

{Light Emitting Device}

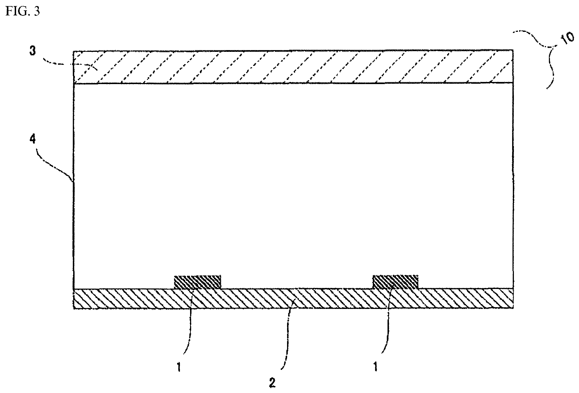

Another embodiment of the present invention is a light emitting device including a sintered phosphor and a semiconductor light emitting element. The light emitting device of the present invention includes at least a semiconductor blue light emitting element (blue light emitting diode or blue semiconductor laser) and the sintered phosphor according to the embodiment of the present invention, which is a wavelength conversion member that converts the wavelength of blue light. The semiconductor blue light emitting element and the sintered phosphor may be brought into close contact with each other or may be separated from each other, and a transparent resin or a space may be included therebetween. As shown as a schematic view in Fig. 3, a structure including a space between the semiconductor light emitting element and the sintered phosphor is preferable.

In addition, in order to effectively introduce the light of the semiconductor blue light emitting element into the sintered phosphor of the embodiment, an embodiment in which the semiconductor blue light emitting element and the sintered phosphor are brought into close contact with each other is preferable. In this case, it is preferable that the sintered phosphor and the semiconductor blue light emitting element are bonded with an adhesive having high heat resistance and thermal conductivity to promote mutual heat conduction.

As the adhesive having high heat resistance, a silicone resin-based adhesive is preferable. The silicone resin-based adhesive preferably includes a filler (fine particles) for improving thermal conductivity. In order to increase mutual heat conduction between the sintered phosphor and the semiconductor blue light emitting element, it is preferable that the thickness of the adhesive is made thick as much as possible, and the thickness is preferably 5 microns or less and more preferably 2 microns or less.

A structure in which the sintered phosphor and the semiconductor blue light emitting element are brought into close contact with each other using another structural contrivance without using an adhesive is also preferable from the viewpoint that the heat resistant temperature of the entire light emitting element can be increased. This is because in a case of using the silicone resin-based adhesive, the light emitting device cannot be used at a temperature higher than the heat resistant temperature of the silicone resin-based adhesive which is generally said to be about 200°C or the durability is deteriorated even in a case where the light emitting device can be used.

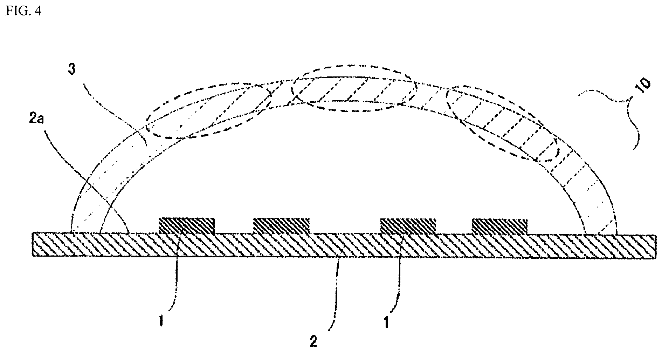

The configuration thereof will be described below with reference to Figs. 3 and 4.

Fig. 4 is a schematic view of the light emitting device according to the specific embodiment of the present invention. A light emitting device 10 includes at least semiconductor blue light emitting elements 1 and a sintered phosphor 3 as constitutional members. The semiconductor blue light emitting elements 1 emit excitation light for exciting a phosphor contained in the sintered phosphor 3.

The semiconductor blue light emitting elements 1 typically emit excitation light having a peak wavelength of 425 nm to 475 nm, and preferably emit excitation light having a peak wavelength of 430 nm to 470 nm. The number of the semiconductor blue light emitting elements 1 can be set as appropriate according to the intensity of excitation light, required by the device.

On the other hand, instead of using the semiconductor blue light emitting elements 1, semiconductor purple light emitting elements can be used. The semiconductor purple light emitting elements typically emit excitation light having a peak wavelength of 390 nm to 425 nm, and preferably emit excitation light having a peak wavelength of 395 to 415 nm.

As the semiconductor blue or purple light emitting element, an indium gallium nitride-based light emitting diode (LED) or indium gallium nitride-based semiconductor laser is preferable.

The optical output intensity (radiant flux) of the semiconductor blue or purple light emitting element is preferably 1.0 W or more per 1 $mm^2$ emission area of the light emitting element, more preferably 2.0 W or more, and particularly preferably 3.0 W or more. By combining a high power semiconductor light emitting element and the sintered phosphor of the present invention, a light emitting element and an illumination apparatus with a large amount of light can be constituted. In a case of using a color conversion material in which a phosphor is mixed with a generally used silicone resin, the heat resistance and durability of the silicone resin are not sufficient and thus such a high power semiconductor light emitting element cannot be used.

The semiconductor blue light emitting elements 1 are mounted on a chip-mounted surface 2a of a wiring substrate 2. A wiring pattern (not shown) for supplying an electrode to the semiconductor blue light emitting elements 1 is formed on the wiring substrate 2, and constitutes an electric circuit. A case where the sintered phosphor 3 is put on the wiring substrate 2 is shown in Fig. 4, but other cases may be acceptable, and the wiring substrate 2 and the sintered phosphor 3, between which another member is interposed, may be arranged.

For example, in Fig. 3, the wiring substrate 2 and the sintered phosphor 3, between which a frame 4 is interposed, are arranged. The frame 4 may have a tapered shape in order to allow light to have directivity. The frame 4 may also be a reflective material.

From the viewpoint of improving the emission efficacy of the light emitting device 10, it is preferable that the wiring substrate 2 has excellent electrical insulation properties, favorable heat dissipation properties, and a high reflectance. However, a reflection plate having a high reflectance may also be disposed on a portion, on which the semiconductor blue light emitting elements 1 are not present, of the chip-mounted surface of the wiring substrate 2 or on at least part of the inner surface of the other member that connects the wiring substrate 2 and the sintered phosphor 3 to each other.

The sintered phosphor 3 converts the wavelength of part of incident light emitted by the semiconductor blue or purple light emitting elements 1, and radiates outgoing light of which the wavelength is different from that of the incident light. The sintered phosphor 3 contains a fluoride inorganic binder and a nitride phosphor. The sintered phosphor can contain one or plurality of another nitride phosphor, a garnet-based phosphor that emits yellow or green light, an oxide phosphor that emits blue or green light, and a nitride phosphor that emits red light are not particularly limited, and the kind of the phosphor can be selected according to the target light emission color, color rendering properties, spectrum shape, and the like.

It is preferable that the light emitting device of the present invention is a light emitting device that radiates white light of low color temperature. In the light emitting device that radiates white light, it is preferable that the deviation $d_{uv}$ (= Duv/1000) of the color of the light radiated from the light emitting device, from a black-body radiation locus, is -0.0200 to 0.0200, and the color temperature of the light is 1800 K or more and 5000 K or less. The light emitting device that emits white light is suitably included in an illumination apparatus.

{Illumination Apparatus}

Another embodiment of the present invention is an illumination apparatus including the light emitting device having the sintered phosphor. As described above, since a high total luminous flux is emitted from the light emitting device, a lighting apparatus with a high total luminous flux can be obtained. It is preferable to arrange a diffusion member covering the sintered phosphor in the light emitting device in the lighting apparatus so that the color of the sintered phosphor is inconspicuous at lights out.

{Image Display Apparatus}

Another embodiment of the present invention is an image display apparatus including the light emitting device having the sintered phosphor. As described above, particularly, light with a high red light proportion is emitted from the light emitting device of the present invention and thus by using the light emitting device as a backlight, an image display apparatus with excellent color balance can be obtained.

In particular, in a case of a projector type display requiring a large amount of light, it is difficult to emit red light with high efficiency. Thus, by using the light emitting device using the sintered phosphor of the present embodiment, light it is possible to obtain an excellent projector type display with high red light efficiency.

{Vehicle Lighting Fixture and Indicating Lamp}

Another embodiment of the present invention is a vehicle lighting fixture and indicating lamp including the light emitting device having the sintered phosphor. The light emitting device can be used as a vehicle lighting fixture such as a high power headlight, a clearance lamp, a position light, a small lamp, a fog lamp, a daytime running light, or an interior light. In addition, since the sintered phosphor of the embodiment emits light with a high red light proportion, the sintered phosphor can be suitably used for a tail lamp, a brake light (stop lamp), and a direction indicating lamp (turn lamp) for a vehicle by being appropriately used with a filter or mirror in combination.

EXAMPLES

Hereinafter, the present invention will now be described in more detail with reference to examples. However, the present invention is not limited to the following examples as long as there is no departure from the scope of the present invention as defined in the claims.

{Measurement Method}

[Emission Properties]

Each sample was placed into a copper sample holder, and the emission spectrum was measured using MCPD 7000 (manufactured by Otsuka Electronics Co., Ltd.). Under the condition of excitation light of 455 nm, the emission intensity of each wavelength within a wavelength range of 380 nm or more and 800 nm or less was measured by using the spectrometer to obtain each emission spectrum.

The chromaticity coordinates were calculated based on the data on the emission spectrum obtained by the above-described method in a wavelength range of 480 nm to 780 nm using a method conforming to the JIS Z 8724 (1997) standard, as the chromaticity coordinates x and y of the XYZ color system specified in JIS Z 8701 (1999) standard.

The relative luminance is expressed as a relative value in a case where the Y value in the XYZ color system when Example 5 is excited at a wavelength of 455 nm is 100. In addition, the emission peak wavelength (hereinafter, sometimes referred to as "peak wavelength") and the half-bandwidth of the emission peak are read from the obtained emission spectrum.

[Powder X-Ray Diffraction Measurement]

The precise measurement of powder X-ray diffraction (XRD) was performed using a powder X-ray diffraction apparatus X'Pert PRO MPD (manufactured by PANalytical Inc.). The measurement conditions are as follows.

CuK$\alpha$ bulb was used

X-ray output: 45 KV, 40 mA
Measurement range: $2\theta$ = 10° to 150°
Read width: 0.008°

From the peak position of the diffraction pattern obtained by the powder X-ray diffraction and the space group (P4bm) of LYSN, the unit lattice was refined and each lattice constant was calculated.

[Temperature Property Measurement (Emission Intensity Maintenance Rate)]

Using a fluorescence spectrophotometer F-7000 (manufactured by Hitachi High-Tech Science Corporation) and a temperature control unit, the emission peak intensity at each temperature of 25°C, 100°C, 200°C, and 300°C was measured and the maintenance rates were compared.

{Production of Phosphor}

(Example 1)

An alloy of La:Si = 1:1 (molar ratio), $Si_3N_4$, $Y_2O_3$, and $CeF_3$ were weighed such that the composition ratio became La:Y:Ce:Si = 3.00:0.41:0.24:6.0 (molar ratio), and were mixed. These operations were performed in a glovebox in a nitrogen atmosphere at an oxygen concentration of 1%.

A molybdenum crucible was filled with the mixed raw material and was set in an electric furnace. The inside of the apparatus was evacuated, followed by increasing the temperature in the furnace to 120°C. After confirmation that vacuum pressure was achieved in the furnace, a hydrogen-containing nitrogen gas (nitrogen:hydrogen = 96:4 (volume ratio)) was introduced until atmospheric pressure was achieved. Then, the temperature in the furnace was increased to 1550°C and held at 1550°C for 8 hours, followed by performing cooling to room temperature to obtain a baked product. The baked product was pulverized with a ball mill, stirred in IN hydrochloric acid for 1 hour or longer, and then washed with water. Then, the resultant was dehydrated and dried by a hot air dryer at 120°C to obtain a phosphor of Example 1.

(Examples 2 to 5)

Phosphors of Examples 2 to 5 were obtained in the same manner as in Example 1 except that the preparation compositional ratio was changed as shown in Table 1.

[Table 1]

Table 1

|  | La | Y | Ce | Si |
|---|---|---|---|---|
| Example 2 | 2.90 | 0.39 | 0.26 | 6.00 |
| Example 3 | 2.90 | 0.39 | 0.35 | 6.00 |
| Example 4 | 2.90 | 0.45 | 0.35 | 6.00 |
| Example 5 | 2.90 | 0.45 | 0.66 | 6.00 |

(Comparative Example 1)

A phosphor of Comparative Example 1 was obtained in the same manner as in Example 1 except that in Example 1, the raw materials were weighed such that the mixing ratio thereof became La:Y:Ce:Si = 3.00:0.41:0.20:6.00 (molar ratio).

(Comparative Example 2)

A phosphor of Comparative Example 2 was obtained in the same manner as in Comparative Example 1 except that in Comparative Example 1, after dehydration and drying, a vapor treatment was performed in an autoclave at 135°C and 0.33 MPa for 20 hours.

(Comparative Example 3)

A phosphor of Comparative Example 3 was obtained in the same manner as in Comparative Example 1 except that in Comparative Example 1, $Y_2O_3$ was changed to $La_2O_3$ without changing the molar amount to be mixed.

(Example 6)

A phosphor of Example 6 was obtained in the same manner as in Example 5 except that the top temperature holding time at the time of firing was changed from 8 hours to 16 hours.

(Example 7)

A phosphor of Example 7 was obtained in the same manner as in Example 5 except that in Example 5, the kinds of raw materials were changed to an alloy of La:Si = 1:1 (molar ratio), $Si_3N_4$, $Y_2O_3$, $YF_3$, and $CeF_3$, the ratio was set to $YF_3$:$Y_2O_3$ = 1.00:3.62 (molar ratio), and the preparation element ratio was set to La:Y:Ce:Si = 2.90:0.45:0.35:6.00 (molar ratio).

(Example 8)

A phosphor of Example 8 was obtained in the same manner as in Example 5 except that in Example 5, the kinds of raw materials were changed to an alloy of La:Si = 1:1 (molar ratio), $Si_3N_4$, $Y_2O_3$, $YF_3$, and $CeF_3$, the ratio was set to $YF_3$:$Y_2O_3$ = 1.00:1.81 (molar ratio), and the preparation element ratio was set to La:Y:Ce:Si = 2.90:0.50:0.66:6.00 (molar ratio).

(Comparative Example 4)

A phosphor of Comparative Example 4 was obtained in the same manner as in Comparative Example 1 except that in Comparative Example 1, the raw materials were weighed such that the mixing ratio thereof became La:Y:Ce:Si = 2.64:0.36:0.45:6.00 (molar ratio), and the top temperature holding time at the time of firing was changed from 8 hours to 23 hours.

(Comparative Example 5)

A phosphor of Comparative Example 5 was obtained in the same manner as in Comparative Example 4 except that in Comparative Example 4, the raw materials were weighed such that the mixing ratio thereof became La:Y:Ce:Si = 2.53:0.34:0.43:6.00 (molar ratio).

{Structural and Emission Properties}

Regarding the phosphors of Examples 1 to 8 and Comparative Examples 1 to 5, the lattice constants calculated from the XRD measurement results and the emission properties (chromaticity coordinates x and y, and emission peak wavelength) are shown in Table 2.

[Table 2]

Table 2

|  | Lattice constant a | Lattice constant c | w2 | x2/(w2 + x2) | z2 | Chromaticity coordinates | | Emission peak wavelength (nm) |
| --- | --- | --- | --- | --- | --- | --- | --- | --- |
|  |  |  |  |  |  | x | y |  |
| Example 1 | 10.153 | 4.841 | 3.00 | 0.120 | 0.24 | 0.455 | 0.533 | 547 |
| Example 2 | 10.152 | 4.841 | 2.90 | 0.120 | 0.26 | 0.456 | 0.532 | 547 |
| Example 3 | 10.152 | 4.841 | 2.90 | 0.120 | 0.35 | 0.459 | 0.530 | 548 |
| Example 4 | 10.146 | 4.841 | 2.90 | 0.134 | 0.35 | 0.463 | 0.527 | 549 |
| Example 5 | 10.139 | 4.841 | 2.90 | 0.134 | 0.35 | 0.479 | 0.514 | 555 |
| Example 6 | 10.139 | 4.841 | 2.90 | 0.134 | 0.66 | 0.476 | 0.517 | 554 |
| Example 7 | 10.145 | 4.841 | 2.90 | 0.134 | 0.35 | 0.466 | 0.525 | 550 |
| Example 8 | 10.133 | 4.841 | 2.90 | 0.148 | 0.66 | 0.489 | 0.505 | 557 |
| Comparative Example 1 | 10.156 | 4.841 | 3.00 | 0.120 | 0.20 | 0.454 | 0.534 | 545 |
| Comparative Example 2 | 10.155 | 4.841 | 3.00 | 0.120 | 0.20 | 0.450 | 0.536 | 545 |
| Comparative Example 3 | 10.189 | 4.841 | 3.41 | 0.000 | 0.20 | 0.424 | 0.556 | 536 |
| Comparative Example 4 | 10.141 | 4.841 | 2.64 | 0.120 | 0.45 | 0.470 | 0.521 | 552 |
| Comparative Example 5 | 10.139 | 4.840 | 2.53 | 0.120 | 0.43 | 0.477 | 0.515 | 554 |

As shown in Table 2, the LYSN phosphor of the present invention has an emission peak having a longer wavelength range than that of a conventional LYSN phosphor. Therefore, the light emitting device including the phosphor of the present invention has a low color temperature even without using a red phosphor.

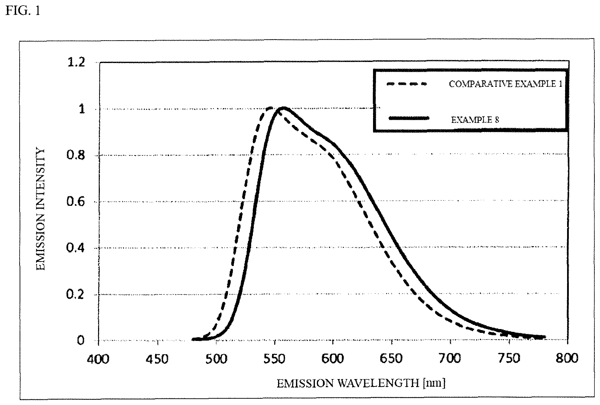

Fig. 1 shows a graph showing the emission spectra of the phosphors obtained in Example 8 and Comparative Example 1. In addition, in Table 3, the results of measuring the emission luminance of the phosphors of Examples 5 and 6, and Comparative Examples 4 and 5, which have similar emission chromaticities, are shown. In addition, the emission luminance is expressed as a relative value in a case where the emission luminance of the phosphor in Example 5 is 100.

[Table 3]

Table 3

| | Chromaticity coordinates | | Emission luminance |
|---|---|---|---|
| | x | y | |
| Example 5 | 0.479 | 0.514 | 100 |
| Example 6 | 0.476 | 0.517 | 100 |
| Comparative Example 4 | 0.470 | 0.521 | 92 |
| Comparative Example 5 | 0.477 | 0.515 | 86 |

As shown in Table 3, it is determined that the emission luminance of the phosphors of Examples 5 and 6 is further increased than the phosphors of Comparative Examples 4 and 5 in which the w value are out of the range by 8 points or greater. This is assumed that in the phosphor of the present invention, a Si-rich different phase such as $LaSi_3N_5$ is not easily formed and emission inhibition is low due to the different phase.

In Table 4, the composition analysis results of samples other than Example 6 by ICP-OES analysis are shown.

[Table 4]

Table 4

| No. | Composition analysis result Si = 6 | | | | | |
|---|---|---|---|---|---|---|
| | La | Ce | Y | Y/La + Y | La + Ce + Y | Si |
| Example 1 | 2.48 | 0.25 | 0.36 | 0.13 | 3.09 | 6.00 |
| Example 2 | 2.43 | 0.28 | 0.37 | 0.14 | 3.08 | 6.00 |
| Example 3 | 2.34 | 0.33 | 0.34 | 0.13 | 3.01 | 6.00 |
| Example 4 | 2.28 | 0.33 | 0.39 | 0.15 | 3.00 | 6.00 |
| Example 5 | 1.95 | 0.59 | 0.40 | 0.16 | 2.95 | 6.00 |
| Example 7 | 2.26 | 0.33 | 0.40 | 0.15 | 2.99 | 6.00 |
| Example 8 | 1.93 | 0.59 | 0.47 | 0.19 | 2.98 | 6.00 |
| Comparative Example 1 | 2.50 | 0.19 | 0.38 | 0.14 | 3.08 | 6.00 |
| Comparative Example 2 | 2.36 | 0.18 | 0.37 | 0.15 | 2.91 | 6.00 |
| Comparative Example 3 | 2.86 | 0.19 | 0.00 | 0 | 3.05 | 6.00 |
| Comparative Example 4 | 1.98 | 0.43 | 0.33 | 0.14 | 2.74 | 6.00 |
| Comparative Example 5 | 1.88 | 0.32 | 0.56 | 0.25 | 2.77 | 6.00 |

As shown in Table 4, in Comparative Examples 4 and 5 with low luminance, the content of Si is larger than the content of Si in Example 5, and as a result, it is found that the total amount of La, Ce, and Y is lower than 3.00 which is a stoichiometric ratio. From the result, it is assumed that in Comparative Examples 4 and 5 in which the preparation amount of La is small, a Si-rich component different from $La_3Si_6N_{11}$ is included.

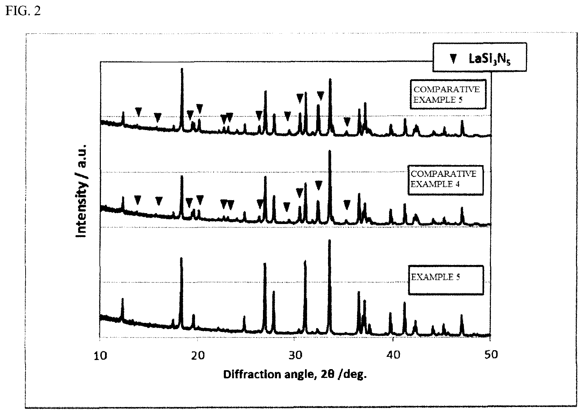

The XRD patterns of Example 5 and Comparative Examples 4 and 5 are shown in Fig. 2. As shown in Fig. 2, it is considered that in Comparative Examples 4 and 5, the confirmation of a large amount of $LaSi_3N_5$ causes significant deviation of the composition from the stoichiometric ratio, and thus the powder luminance is decreased.

In addition, in order to confirm the emission peak intensity maintenance rate with respect to the temperature of the phosphor, the results of measuring the chromaticity coordinates (x,y) and temperature properties of the phosphors of Examples 2, 5, and 8 at room temperature are shown in Table 5.

The results of measuring the chromaticity coordinates and temperature properties of a YAG phosphor BY-102/J (manufactured by Mitsubishi Chemical Corporation) as Reference Example 1, and BY-102/Q (manufactured by Mitsubishi Chemical Corporation) as Reference Example 2 in the same manner are shown in Table 5. In addition, the relative emission peak intensity at 100°C, 200°C, and 300°C is shown in Table 5 when the emission peak intensity at 25°C is 100%.

[Table 5]

Table 5

| | Chromaticity coordinates | | Emission Peak Intensity (%) | | | |
|---|---|---|---|---|---|---|
| | x | y | 25°C | 100°C | 200°C | 300°C |
| Example 2 | 0.456 | 0.532 | 100 | 99 | 93 | 50 |
| Example 5 | 0.479 | 0.514 | 100 | 97 | 92 | 41 |
| Example 8 | 0.489 | 0.505 | 100 | 98 | 92 | 42 |
| Reference Example 1 | 0.452 | 0.536 | 100 | 97 | 82 | 45 |
| Reference Example 2 | 0.461 | 0.528 | 100 | 95 | 76 | 37 |

As shown in Table 5, the emission peak intensity maintenance rate of Example 2 at high temperature is higher than that of Reference Example 1, the emission peak intensity maintenance rates of Examples 5 and 8 at high temperature are higher than that of Reference Example 2, and even in a case of comparison with YAG exhibiting the same color or longer wavelength light emission and the phosphors, it is determined that the emission peak is maintained.

Namely, even in a case of comparison with a YAG phosphor widely used for an LED and the LYSN phosphor of the present invention, the emission peak intensity is preferentially maintained even in the emission chromaticity range can be realized in the present invention or the like, and the temperature quenching is small.

Therefore, the phosphor of the present invention makes it possible to maintain high performance even with high power LED exposed to a high temperature. Namely, the light emitting device including the phosphor of the present invention is less likely to have color shift and is high quality.

{Production and Evaluation of Light Emitting Device}

Light emitting devices were prepared by using the phosphors of Comparative Example 1 and Examples 1, 3, and 5 to 8 to confirm the color temperature.

In order to evaluate white color in the light emitting device, the phosphors of Examples 1, 3, and 5 to 8 and the phosphor of Comparative Example 1, and the silicone resin were mixed and dispersed with a stirring and defoaming apparatus to prepare each resin paste. The resin paste was combined with a blue light LED chip of an emission wavelength of 445 to 455 nm such that the amount of resin paste was adjusted to y = 0.352, and thus a light emitting device was prepared.

The chromaticity coordinates x and y and the temperature of color to be reproduced of each light emitting device prepared at this time are shown in Table 6.

[Table 6]

Table 6

| | Phosphor | Chromaticity coordinates | | Color temperature (K) |
|---|---|---|---|---|
| | | x | y | |
| Comparative Example 6 | Comparative Example 1 | 0.343 | 0.351 | 5088 |

(continued)

|  | Phosphor | Chromaticity coordinates | | Color temperature (K) |
|---|---|---|---|---|
|  |  | x | y |  |
| Example 9 | Example 1 | 0.346 | 0.352 | 4988 |
| Example 10 | Example 3 | 0.347 | 0.352 | 4933 |
| Example 11 | Example 4 | 0.350 | 0.352 | 4811 |
| Example 12 | Example 5 | 0.366 | 0.352 | 4256 |
| Example 13 | Example 7 | 0.351 | 0.352 | 4784 |
| Example 14 | Example 8 | 0.375 | 0.352 | 3966 |

As shown in Table 6, it is determined that in the light emitting device including the phosphor of the present invention, without using other red and green phosphors, a low color temperature of 5000 K or less is realized.

In the following examples, the sintering degree, the emission properties of the phosphor, the lattice constants of the phosphor, the optical properties, and the transmittance were measured as follows.

(Sintering Degree)

The sintering degree was calculated by dividing the density $\rho_a$ of the sintered phosphor measured by an Archimedes method, by a theoretical density $\rho_{theoretical}$.

$$\text{Sintering degree (\%)} = (\rho_a/\rho_{theoretical}) \times 100$$

[Emission Properties of Phosphor]

The emission properties were measured in the same manner as above.

[Lattice Constant Measurement of Phosphor (Powder X-Ray Diffraction Measurement)]

The precise measurement of powder X-ray diffraction (XRD) was performed using a powder X-ray diffraction apparatus X'Pert PRO MPD (manufactured by PANalytical Inc.). The measurement conditions are as follows.

CuKα bulb was used

X-ray output: 45 KV, 40 mA
Measurement range: $2\theta = 10°$ to $150°$
Read width: 0.008°

The lattice constants a and c were obtained by pattern fitting using the obtained diffraction patterns. The pattern fitting was performed based on the crystal structure of $La_3Si_6N_{11}$ (space group P4bm).

(Optical Properties)

There was produced a light emitting device capable of emitting light from the sintered phosphor by irradiation of blue light emitted from an LED chip (at a peak wavelength of 454 nm). The emission spectra from the device were observed using a 40-inch integrating sphere (manufactured by LabSphere Inc.), and a spectroscope MCPD 9000 (manufactured by manufactured by Otsuka Electronics Co., Ltd.) to measure correlated color temperature chromaticity coordinates, and a luminous flux (lumen) in pulse excitation by light having a radiant flux of 0.26 W. Further, a conversion efficacy (lm/W) was calculated at each intensity from the luminous flux (lumen) and the radiant flux (W) of the LED chip.

Next, a xenon spectral light source was used as a light source, the excitation wavelength was set to 700 nm, and the transmittance of the sintered phosphor at an excitation wavelength of 700 nm was measured from the reflection and transmission spectra at irradiation of the sintered phosphor.

Subsequently, the excitation wavelength was changed to 450 nm, the internal quantum efficiency and absorption rate of the sintered phosphor at an excitation wavelength of 450 nm were measured from the reflection and transmission spectra at irradiation of the sintered phosphor.

Reflections and transmission spectra were observed with a 20-inch integrating sphere LMS-200 (manufactured by Labsphere, Inc.) and a spectroscope Solid Lambda UV-Vis (manufactured by Carl Zeiss) using a spectroscopic light source (manufactured by Spectra Coop).

(Example 15)

[Production of LYSN Phosphor]

An LYSN phosphor 1 was obtained in the same manner as in Example 8. The median particle diameter of the phosphor was 30 $\mu$m.

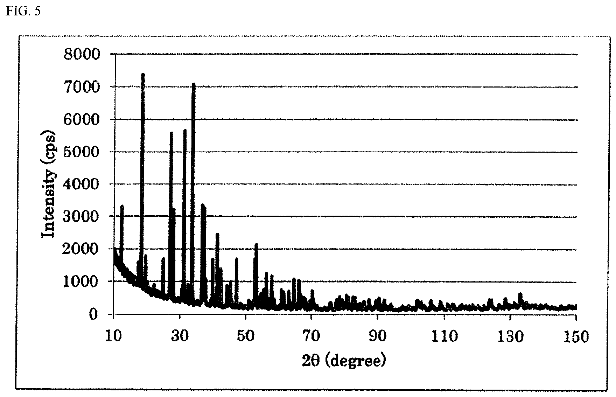

The powder X-ray diffraction pattern of the phosphor is shown in Fig. 5. The results of calculating the lattice constants a and c based on the data are shown in Table 7. In addition, the measurement results of the emission properties are shown in Table 7.

[Preparation of Sintered Phosphor]

Each of 2.0 g of a $CaF_2$ powder (manufactured by Hakushin Chemical Laboratory Co., Ltd., fine particles of 1 $\mu$m or less) used as a fluoride inorganic binder material in a sintered phosphor, and 0.27 g of the LYSN phosphor 1 $((La,Y)_3Si_6N_{11}:Ce)$ was weighed such that the concentration of the phosphor in the sintered body was 8% by volume. The materials were mixed using a mortar. These powders were dry-mixed for 2 hours by rotation on a ballless ball mill stand to offer a raw material for sintering.

In a uniaxial pressing die (made of stainless steel and having a diameter $\Phi$ of 20 mm) including an upper punch, a lower punch, and a columnar die, 2.0 g of the raw material was set, pressed and pressurized with 10 tons, and held for 5 minutes and then the pressure was released, to obtain pellets having a diameter $\Phi$ of 20 mm and a thickness of 3 mm.

The obtained pellets were vacuum-lamination-packed, introduced into a cold isostatic pressing (CIP) apparatus (rubber press, manufactured by NIKKISO CO., LTD.), and pressurized at 300 MPa for 1 minute. Then, the resultant was introduced into a firing furnace (tubular furnace) (tubular furnace, manufactured by IRH Irie Seisakusho), the temperature was increased to 1200°C at 10 °C/min and held for 60 minutes, and the furnace was then cooled to obtain a sintered body having a diameter $\Phi$ of 18 mm and a thickness of 3 mm. The sintering density of the sintered body was measured by the above method.

(Grinding and Evaluation)

The obtained sintered phosphor having a diameter $\Phi$ of 18 mm and a thickness of 3 mm was cut to have a thickness of about 0.5 mm with a diamond cutter from the sintered phosphor, and was further ground by a grinder to prepare a sintered phosphor a diameter $\Phi$ of 18 mm and a thickness of 0.2 mm.

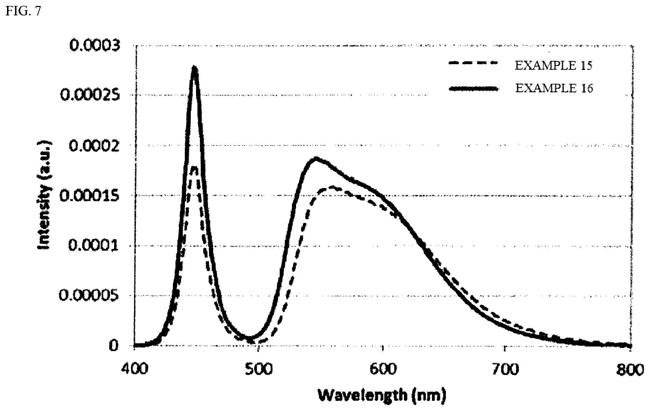

The transmittance and internal quantum efficiency at a wavelength of 700 nm and the absorption rate at 450 nm were measured using the sintered phosphor. Further, a light emitting device was prepared by the above method, and total luminous flux, conversion efficacy, chromaticity coordinates, correlated color temperature, and the deviation $D_{UV}$ (= $d_{uv} \times 1000$) were measured. The color rendering property evaluation indexes (Ra, and R1 to R15) were examined. The obtained results are shown in Tables 8 to 10. In addition, the emission spectrum by LED excitation is shown in Fig. 7.

(Example 16)

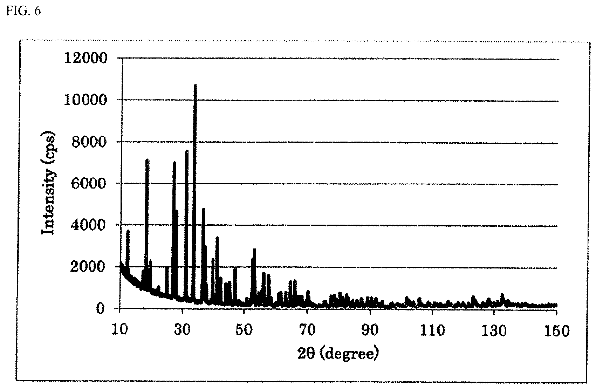

An LYSN phosphor 2 was obtained in the same manner as in Example 2. The median particle diameter of the phosphor was 20 $\mu$m. The powder X-ray diffraction pattern of the phosphor is shown in Fig. 6. The results of calculating the lattice constants a and c based on the data are shown in Table 7. In addition, the measurement results of the emission properties are shown in Table 7.

A sintered phosphor was obtained by using the phosphor according to the procedure of [Preparation of Sintered Phosphor] of Example 15. However, the amount of the phosphor added was set to 0.2 g such that the amount of the phosphor with respect to 2.0 g of $CaF_2$ became 6% by volume.

For this sintered phosphor, as an additional heat treatment, the temperature was increased to 1100°C in an Ar atmosphere by a hot isostatic pressing apparatus (HIP) and held at 100 MPa for 1 hour. Thus, a sintered phosphor of Example 16 having a diameter $\Phi$ of 18 mm and a thickness of 3 mm was obtained.

The subsequent working and evaluation were performed in the same manner as in Example 15, and the same evaluation results were obtained. In addition, the color rendering property evaluation indexes (Ra and R1 to R15) were examined. The obtained results are shown in Tables 8 to 10. The emission spectrum by LED excitation is shown in Fig. 7.

[Table 7]

Table 7 Lattice constant and emission properties of nitride phosphor

| | w | x | z | Lattice constant a (A) | Lattice constant c (A) | Chromaticity coordinate x | Chromaticity coordinate y | Emission peak wavelength (nm) |
|---|---|---|---|---|---|---|---|---|
| LYSN phosphor 1 | 2.90 | 0.5 | 0.66 | 10.133 | 4.841 | 0.489 | 0.505 | 557 |
| LYSN phosphor 2 | 2.90 | 0.39 | 0.26 | 10.152 | 4.841 | 0.456 | 0.532 | 547 |

[Table 8]

Table 8 Properties of sintered phosphor

| | Sintering density (%) | Transmittance (%) @700 nm | Quantum yield (%) | Absorption rate (%) @450 nm |
|---|---|---|---|---|
| Example 15 | 90.9 | 48 | 78 | 70 |
| Example 16 | 99.4 | 59 | 85 | 74 |

As shown in Table 8, the sintered phosphor of the embodiment has high sintering density and transmittance. Further, the sintered body of the present invention has high quantum yield and absorption rate of excitation light (450 nm).

[Table 9]

Table 9 Properties of light emitting device using sintered phosphor of embodiment

| | Blue LED radiant flux (W) | Chromaticity coordinate x | Chromaticity coordinate Y | Correlated color temperature (K) | Deviation $D_{UV}$ | Total luminous flux (lm) | Conversion efficiency (lm/w) |
|---|---|---|---|---|---|---|---|
| Example 15 | 0.26 | 0.399 | 0.379 | 3541 | -3.6 | 33 | 124 |
| Example 16 | 0.26 | 0.361 | 0.366 | 4508 | 1.0 | 38 | 165 |
| * In both cases, the blue LED wavelength was measured at 454 nm. | | | | | | | |

[Table 10]

Table 10

|  | Ra | R01 | R02 | R03 | R04 | R05 | R06 | R07 | R08 | R09 | R10 | R11 | R12 | R13 | R14 | R15 |
|---|---|---|---|---|---|---|---|---|---|---|---|---|---|---|---|---|
| Example 15 | 62.0 | 60.3 | 71.4 | 71.8 | 56.8 | 55.0 | 51.2 | 78.6 | 51.0 | -29.7 | 24.5 | 38.6 | 10.8 | 61.2 | 82.7 | 61.3 |
| Example 16 | 64.7 | 64.1 | 70.5 | 68.5 | 64.7 | 60.9 | 54.0 | 79.0 | 56.3 | -30.9 | 23.1 | 53.6 | 15.9 | 64.2 | 81.1 | 62.0 |

As shown in Tables 9 and 10, in the light emitting device using the sintered phosphor of the embodiment, high emission efficiency and high luminance can be achieved and light in a low color temperature range with a large number of red color components can be emitted.

(Example 17)

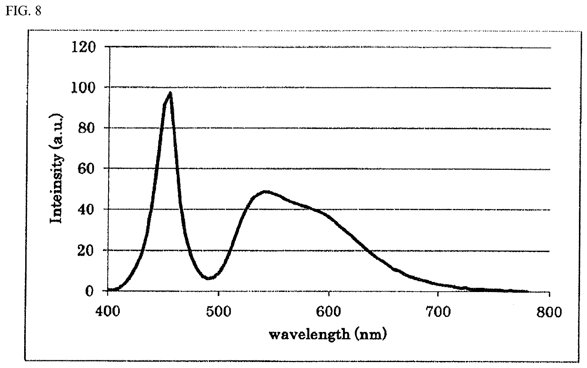

The emission spectrum of a light emitting device with a correlated color temperature of 6500 K prepared using a blue LED having a peak wavelength of 454 nm, an LYSN phosphor 2, and an LSN phosphor ($La_3Si_6N_{11}$:Ce) BY-201/F (manufactured by Mitsubishi Chemical Corporation) is calculated by simulation and shown in Fig. 8. The chromaticity coordinates x and y, color rendering property evaluation indexes (Ra and R1 to R15), correlated color temperature, and deviation $D_{UV}$ of the light emitting device are shown in Table 11.

(Example 18)

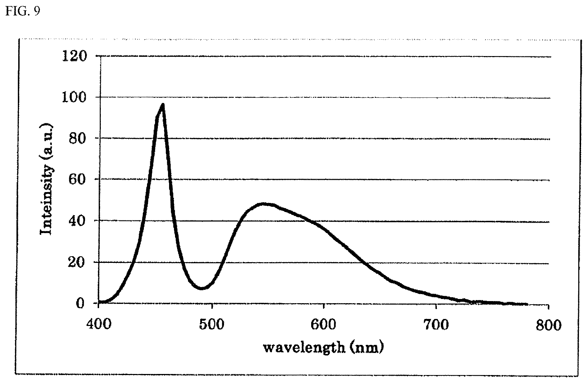

The spectrum of a light emitting device with a correlated color temperature of 6500 K by performing simulation in the same manner as in Example 17 except that in Example 17, instead of using the LSN phosphor BY-201/F, a YAG phosphor ($Y_3Al_5O_{12}$:Ce) BY-102/H (manufactured by Mitsubishi Chemical Corporation) was used. The results are shown in Fig. 9. The chromaticity coordinates x and y, color rendering property evaluation indexes (Ra and R1 to R15), correlated color temperature, and deviation Duv of the light emitting device are shown in Table 11.

[Table 11]

Table 11

| | Chromaticity coordinate x | Chromaticity coordinate Y | CCT (K) | $D_{uv}$ | Ra | R1 | R2 | R3 | R4 | R5 | R6 | R7 | R8 | R9 | R10 | R11 | R12 | R13 | R14 | R15 |
|---|---|---|---|---|---|---|---|---|---|---|---|---|---|---|---|---|---|---|---|---|
| Example 17 | 0.3135 | 0.3235 | 6500 | 0.0 | 72.4 | 72.5 | 76.5 | 73.1 | 73.6 | 71.1 | 64.8 | 83.2 | 64.8 | -16.6 | 37.6 | 67.6 | 33.1 | 73.1 | 84.2 | 70.3 |
| Example 18 | 0.3135 | 0.3235 | 6500 | 0.0 | 72.4 | 72.0 | 76.5 | 74.1 | 73.2 | 70.9 | 65.0 | 83.1 | 64.3 | -17.6 | 38.3 | 67.2 | 34.5 | 72.6 | 84.8 | 69.7 |

As shown in Table 11, the light emitting device of the present invention is a white light emitting device with a correlated color temperature of 6500 K and high efficiency. Since the sintered phosphor containing two phosphors is used in the configuration of the example, a light emitting device is easily produced from the viewpoint that it is possible to offset the influence of variations between the lots of the phosphors by adjusting the formulation ratio of two phosphors at the time of mass production.

(Example 19)

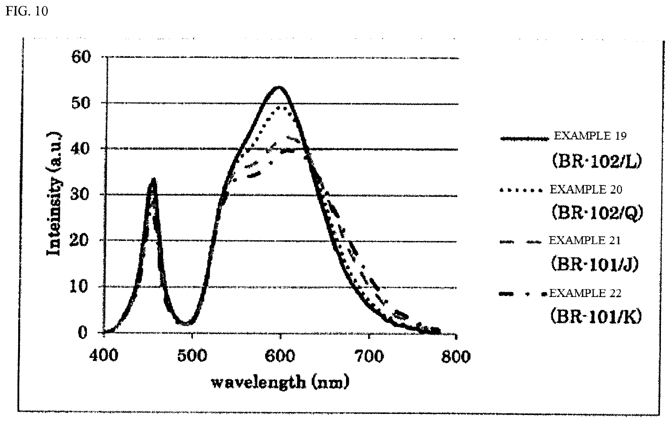

The emission spectrum of a light emitting device with a correlated color temperature of 3000 K prepared using a blue LED having a peak wavelength of 454 nm, an LYSN phosphor 2, and a SCASN phosphor ((Sr,Ca)AlSiN$_3$:Eu)BR-102/L (manufactured by Mitsubishi Chemical Corporation) as a nitride red phosphor is calculated by simulation and shown in Fig. 10. The chromaticity coordinates x and y, color rendering property evaluation indexes (Ra and R1 to R15), correlated color temperature, and deviation Duv of the light emitting device are shown in Table 12.

(Examples 20 to 22)

The emission spectrum of each light emitting device was obtained by simulation in the same manner as Example 19 except that in Example 19, instead of using BR-102/L, a nitride red phosphor was used as a nitride phosphor shown in Table 12. The obtained emission spectrum is shown in Fig. 10. The chromaticity coordinates x and y, color rendering property evaluation indexes (Ra and R1 to R15), correlated color temperature, and deviation Duv of the light emitting device are shown in Table 12.

(Examples 23 to 26)

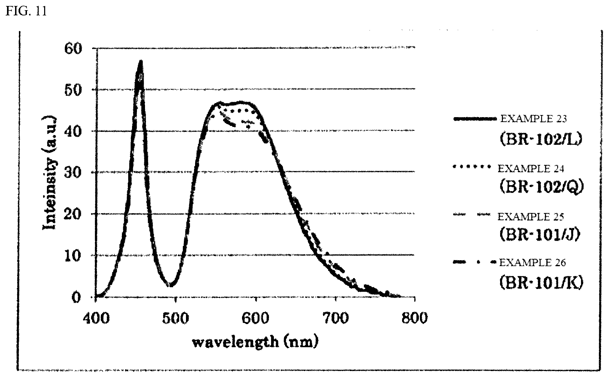

The emission spectrum of a light emitting device was obtained by simulation in the same manner as Example 19 except that the correlated color temperature of the light emitting device was set to 4000 K. The obtained emission spectrum is shown in Fig. 11. The chromaticity coordinates x and y, color rendering property evaluation indexes (Ra and R1 to R15), correlated color temperature, and deviation Duv of the light emitting device are shown in Table 13.

[Table 12]

Table 12

| | Nitride red phosphor | Chromaticity coordinate x | Chromaticity coordinate y | CCT (K) | $D_{uv}$ | Ra | R1 | R2 | R3 | R4 | R5 | R6 | R7 | R8 | R9 | R10 | R11 | R12 | R13 | R14 | R15 |
|---|---|---|---|---|---|---|---|---|---|---|---|---|---|---|---|---|---|---|---|---|---|
| Example 19 | BR-102/L | 0.4368 | 0.4039 | 3000 | 0.0 | 65.8 | 62.8 | 76.9 | 85.7 | 60.1 | 58.9 | 63.5 | 77.5 | 41.3 | -42.1 | 42.2 | 48.1 | 26.1 | 65.1 | 91.0 | 57.4 |
| Example 20 | BR-102/Q | 0.4368 | 0.4039 | 3000 | 0.0 | 69.8 | 68.4 | 78.8 | 83.4 | 66.3 | 64.1 | 66.1 | 81.1 | 50.7 | -20.5 | 45.4 | 55.8 | 29.7 | 69.9 | 89.3 | 64.1 |
| Example 21 | BR-101/J | 0.4368 | 0.4039 | 3000 | 0.0 | 73.8 | 74.1 | 80.4 | 79.8 | 72.0 | 68.9 | 67.4 | 85.2 | 62.8 | 7.4 | 47.6 | 61.7 | 31.7 | 74.6 | 87.0 | 72.1 |
| Example 22 | BR-101/K | 0.4368 | 0.4039 | 3000 | 0.0 | 75.6 | 76.4 | 81.1 | 78.8 | 74.5 | 71.1 | 68.3 | 86.6 | 67.7 | 18.4 | 49.1 | 64.8 | 33.2 | 76.6 | 86.3 | 75.2 |

As shown in Table 12, the light emitting device of the present invention is a light emitting device which emits light with a low color temperature of a correlated color temperature of 3000 K. Since the fluoride inorganic binder having high thermal conductivity is used, it is expected that the emission efficiency is not easily decreased even with a high output from the blue LED exciting the sintered phosphor. In addition, the color rendering properties can be adjusted by changing the kind of the nitride red phosphor, and the conversion efficiency can be improved by suppressing the color rendering properties to be low. Thus, a light emitting device exhibiting desired conversion efficiency, luminous flux, and color rendering properties can be obtained.

[Table 13]

Table 13

| | Nitride red phosphor | Chromaticity coordinate x | Chromaticity coordinate y | CCT (K) | $D_{uv}$ | Ra | R1 | R2 | R3 | R4 | R5 | R6 | R7 | R8 | R9 | R10 | R11 | R12 | R13 | R14 | R15 |
|---|---|---|---|---|---|---|---|---|---|---|---|---|---|---|---|---|---|---|---|---|---|
| Example 23 | BR-102/L | 0.3804 | 0.3768 | 4000 | 0.0 | 67.9 | 66.1 | 75.4 | 77.5 | 65.4 | 62.9 | 61.2 | 81.3 | 53.0 | -30.7 | 36.0 | 54.5 | 23.9 | 67.5 | 86.3 | 62.7 |
| Example 24 | BR-102/Q | 0.3804 | 0.3768 | 4000 | 0.0 | 69.2 | 68.1 | 76.1 | 76.7 | 67.4 | 64.6 | 62.0 | 82.4 | 56.5 | -21.5 | 37.1 | 56.9 | 24.9 | 69.1 | 85.7 | 65.2 |
| Example 25 | BR-101/J | 0.3804 | 0.3768 | 4000 | 0.0 | 70.5 | 70.0 | 76.5 | 75.5 | 69.1 | 66.1 | 62.3 | 83.6 | 60.8 | -10.2 | 37.8 | 58.6 | 25.5 | 70.6 | 85.0 | 68.1 |
| Example 26 | BR-101/K | 0.3804 | 0.3768 | 4000 | 0.0 | 71.0 | 70.7 | 76.7 | 75.2 | 69.9 | 66.8 | 62.5 | 84.0 | 62.4 | -6.0 | 38.2 | 59.5 | 25.8 | 71.2 | 84.8 | 69.2 |

As shown in Table 13, the light emitting device of the present invention is a light emitting device which emits light with a low color temperature of a correlated color temperature of 4000 K. Since the fluoride inorganic binder having high thermal conductivity is used, it is expected that the emission efficiency is not easily decreased even with a high output from the blue LED exciting the sintered phosphor. In addition, the color rendering properties can be adjusted by changing the kind of the nitride red phosphor, and the conversion efficiency can be improved by suppressing the color rendering properties to be low. Thus, a light emitting device exhibiting desired conversion efficiency, luminous flux, and color rendering properties can be obtained.

(Example 27)

A sintered phosphor was obtained in the same manner as in Example 16 using a mixed powder of the LYSN phosphor 2 of Example 16 and an LSN phosphor ($La_3Si_6N_{11}$:Ce) BY-201/G (manufactured by Mitsubishi Chemical Corporation) with a volume ratio of 92:8. The subsequent working and evaluation were performed in the same manner as in Example 15 except that the thickness at the time of working was set to 0.24 mm, and the same evaluation results were obtained. The obtained results are shown in Tables 12 and 14.

(Example 28)

A sintered phosphor was obtained in the same manner as in Example 16 using a mixed powder of the LYSN phosphor 2 of Example 16 and a YAG phosphor BY-102/H (manufactured by Mitsubishi Chemical Corporation) with a volume ratio of 90:10. The subsequent working and evaluation were performed in the same manner as in Example 15 except that the thickness at the time of working was set to 0.24 mm, and the same evaluation results were obtained. The obtained results are shown in Tables 12 and 14.

[Table 14]

Table 14

| | Chromaticity coordinate x | Chromaticity coordinate y | Correlated color temperature (K) | Deviation $D_{UV}$ | Ra |
|---|---|---|---|---|---|
| Example 27 | 0.352 | 0.360 | 4797 | 1.4 | 66 |
| Example 28 | 0.343 | 0.343 | 5074 | -3.6 | 68 |

As shown in Table 14, in the configurations of Examples 27 and 28, since a sintered phosphor containing two phosphors is used, a light emitting device is easily produced from the viewpoint that it is possible to offset the influence of variations between the lots of the phosphors by adjusting the formulation ratio of two phosphors at the time of mass production.

While the present invention has been described in detail and with reference to specific embodiments thereof, it will be apparent to one skilled in the art that various changes and modifications can be made therein without departing from the scope of the present invention as defined in the claims.

**Claims**

1. A phosphor comprising,
   a tetragonal crystal phase,
   wherein the crystal phase has a composition represented by the following Formula (1):

$$La_wA_xSi_6N_yM_z \qquad (1)$$

   wherein in the Formula (1),

M element represents one or more of elements selected from Eu, Ce, Mn, Fe and Pr,
A element represents one or more of elements selected from rare earth elements other than La, Eu, Ce, Mn, Fe and Pr,
w, x, y, and z each independently represents values satisfying the following formulae:

w satisfies $1.50 \leq w \leq 2.7$,
x satisfies $0.2 \leq x \leq 1.5$,
y satisfies $8.0 \leq y \leq 14.0$, and
z satisfies $0.05 \leq z \leq 1.0$,

wherein the crystal phase satisfies the following formulae [I] and [II]:

$$0.10 \leq x/(w + x) \leq 0.50 \quad [\text{I}]$$

$$2.80 \leq w + x + z \leq 3.20 \quad [\text{II}]$$

wherein in formulae [I] and [II],

w represents a content of La element when a molar ratio of Si is 6;
x represents a content of A element when a molar ratio of Si is 6; and
z represents a content of M element when a molar ratio of Si is 6,

wherein a lattice constant a is 1.0104 nm (10.104 Å) or more and 1.0154 nm (10.154 Å) or less.

2. A phosphor comprising,
a tetragonal crystal phase,
wherein the crystal phase has a composition represented by the following
Formula (1):

$$La_wA_xSi_6N_yM_z \qquad (1)$$

wherein in the Formula (1),

M element represents one or more of elements selected from Eu, Ce, Mn, Fe and Pr,
A element represents one or more of elements selected from rare earth elements other than La, Eu, Ce, Mn, Fe and Pr,
w, x, y, and z each independently represents values satisfying the following formulae:

w satisfies $1.50 \leq w \leq 2.7$,
x satisfies $0.2 \leq x \leq 1.5$,
y satisfies $8.0 \leq y \leq 14.0$, and
z satisfies $0.05 \leq z \leq 1.0$,

wherein a lattice constant a is 1.0104 nm (10.104 Å) or more and 1.0154 nm (10.154 Å) or less,
wherein the phosphor is obtained by preparing raw materials such that a ratio of each element included in the raw materials satisfies the following formulae [III] and [IV] and firing the raw materials:

$$0.1 \leq x2/(w2 + x2) \leq 0.5 \quad [\text{III}]$$

$$2.85 \leq w2 \leq 3.2 \qquad [\text{IV}]$$

wherein

w2 represents a preparation amount of La element when a molar ratio of Si is 6; and

x2 represents a preparation amount of A element when a molar ratio of Si is 6.

3. The phosphor according to claim 1 or 2,
wherein the phosphor has an emission peak wavelength in a range of 546 nm or more and 570 nm or less by irradiation with excitation light having a wavelength of 300 nm or more and 460 nm or less.

4. A light emitting device comprising:

a first illuminant; and
a second illuminant that emits visible light by irradiation with light from the first illuminant,
wherein the second illuminant includes one or more nitride phosphors according to any one of claims 1 to 3 as a first phosphor.

5. An illumination apparatus comprising:
the light emitting device according to claim 4 as a light source.

6. An image display apparatus comprising:
the light emitting device according to claim 4 as a light source.

7. A method of producing a phosphor including a crystal phase including M element, La, A element, Si, and N, and having a lattice constant a of 1.0104 nm (10.104 Å) or more and 1.0154 nm (10.154 Å) or less, which comprises: preparing M source, La source, A source, and Si source as raw materials such that a ratio of each element satisfies the following formulae [III] and [IV] and firing the raw materials:

$$0.1 \leq x2/(w2 + x2) \leq 0.5 \quad [III]$$

$$2.85 \leq w2 \leq 3.2 \qquad [IV]$$

wherein M element represents one or more of elements selected from Eu, Ce, Mn, Fe and Pr; and
A element represents one or more of elements selected from rare earth elements other than La and the M elements,
in formulae [III] and [IV],
w2 represents a preparation amount of La element when a molar ratio of Si is 6; and
x2 represents a preparation amount of A element when a molar ratio of Si is 6,
wherein preparation amounts are adjusted such that a composition of metal

elements included in the raw materials satisfies a composition represented by the following Formula (2):

$$La_{w2}A_{x2}Si_6N_{y2}M_{z2} \qquad (2)$$

wherein in the Formula (2),

M element represents one or more of elements selected from Eu, Ce, Mn, Fe and Pr;
A element represents one or more of elements selected from rare earth elements other than La and the M elements,
w2 is a value satisfying the Expression [IV],
x2, y2, and z2 each independently represents values satisfying following formulae:
x2 satisfies $0.2 \leq x2 \leq 1.5$;
y2 satisfies $8.0 \leq y2 \leq 14.0$; and

z2 satisfies $0.05 \leq z2 \leq 1.0$.

**Patentansprüche**

1. Leuchtstoff, umfassend,

eine tetragonale Kristallphase,
wobei die Kristallphase eine Zusammensetzung der folgenden Formel (1) aufweist:

$$La_wA_xSi_6N_yM_z \qquad (1)$$

wobei in der Formel (1),

das Element M für eines oder mehrere von Elementen steht, die aus Eu, Ce, Mn, Fe und Pr ausgewählt sind,
das Element A für eines oder mehrere von Elementen steht, die aus Seltenerdelementen ausgewählt sind, die sich von La, Eu, Ce, Mn, Fe und Pr unterscheiden,
w, x, y und z jeweils unabhängig voneinander für Werte stehen, die die folgenden Formeln erfüllen:

w erfüllt $1,50 \leq w \leq 2,7$,
x erfüllt $0,2 \leq x \leq 1,5$,
y erfüllt $8,0 \leq y \leq 14,0$, und
z erfüllt $0,05 \leq z \leq 1,0$,

wobei die Kristallphase die folgenden Formeln [I] und [II] erfüllt:

$$0,10 \leq x/(w + x) \leq 0,50 \ [I]$$

$$2,80 \leq w + x + z \leq 3,20 \ [II]$$

wobei in den Formeln [I] und [II],

w für einen Gehalt an Element La steht, wenn ein Molverhältnis von Si 6 ist;
x für einen Gehalt an Element A steht, wenn ein Molverhältnis von Si 6 ist; und
z für einen Gehalt an Element M steht, wenn ein Molverhältnis von Si 6 ist,

wobei eine Gitterkonstante a 1,0104 nm (10,104 Å) oder mehr und 1,0154 nm (10,154 Å) oder weniger beträgt.

2. Leuchtstoff, umfassend,
eine tetragonale Kristallphase,
wobei die Kristallphase eine Zusammensetzung der folgenden Formel (1) aufweist:

$$La_wA_xSi_6N_yM_z \qquad (1)$$

wobei in der Formel (1),
das Element M für eines oder mehrere von Elementen steht, die aus Eu, Ce, Mn, Fe und Pr ausgewählt sind,
das Element A für eines oder mehrere von Elementen steht, die aus Seltenerdelementen ausgewählt sind, die sich von La, Eu, Ce, Mn, Fe und Pr unterscheiden,
w, x, y und z jeweils unabhängig voneinander für Werte stehen, die die folgenden Formeln erfüllen:

w erfüllt $1,50 \leq w \leq 2,7$,
x erfüllt $0,2 \leq x \leq 1,5$,
y erfüllt $8,0 \leq y \leq 14,0$, und
z erfüllt $0,05 \leq z \leq 1,0$,

wobei eine Gitterkonstante a 1,0104 nm (10,104 Å) oder mehr und 1,0154 nm (10,154 Å) oder weniger beträgt,
wobei der Leuchtstoff erhalten wird, indem Rohmaterialien so hergestellt werden, dass ein Verhältnis von jedem der in den Rohmaterialien enthaltenen Elemente die folgenden Formeln [III] und [IV] erfüllt, und die Rohmaterialien gebrannt werden:

$$0,1 \leq x2/(w2 + x2) \leq 0,5 \ [III]$$

$$2,85 \leq w2 \leq 3,2 \ [\text{IV}]$$

wobei

w2 für eine Herstellungsmenge des Elements La steht, wenn ein Molverhältnis von Si 6 ist; und
x2 für eine Herstellungsmenge des Elements A steht, wenn ein Molverhältnis von Si 6 ist.

3. Leuchtstoff gemäß Anspruch 1 oder 2,
wobei der Leuchtstoff eine Emissionspeakwellenlänge in einem Bereich von 546 nm oder mehr und 570 nm oder weniger aufweist, wenn er mit Anregungslicht mit einer Wellenlänge von 300 nm oder mehr und 460 nm oder weniger bestrahlt wird.

4. Lichtemittierende Vorrichtung, umfassend:

einen ersten Leuchtkörper; und
einen zweiten Leuchtkörper, der sichtbares Licht emittiert, wenn er mit Licht des ersten Leuchtkörpers bestrahlt wird,
wobei der zweite Leuchtkörper einen oder mehrere Nitrid-Leuchtstoffe gemäß einem der Ansprüche 1 bis 3 als ersten Leuchtstoff enthält.

5. Beleuchtungsvorrichtung, umfassend:
die lichtemittierende Vorrichtung gemäß Anspruch 4 als Lichtquelle.

6. Bildanzeigevorrichtung, umfassend:
die lichtemittierende Vorrichtung gemäß Anspruch 4 als Lichtquelle.

7. Verfahren zur Herstellung eines Leuchtstoffs mit einer Kristallphase, die ein Element M, La, ein Element A, Si und N enthält und eine Gitterkonstante a von 1,0104 nm (10,104 Å) oder mehr und 1,0154 nm (10,154 Å) oder weniger aufweist, umfassend:
Herstellen einer M-Quelle, La-Quelle, A-Quelle und Si-Quelle als Rohmaterialien, so dass ein Verhältnis von jedem Element die folgenden Formeln [III] und [IV] erfüllt, und Brennen der Rohmaterialien:

$$0,1 \leq x2/(w2 + x2) \leq 0,5 \ [\text{III}]$$

$$2,85 \leq w2 \leq 3,2 \ [\text{IV}]$$

wobei das Element M für eines oder mehrere von Elementen steht, die aus Eu, Ce, Mn, Fe und Pr ausgewählt werden; und
das Element A für eines oder mehrere von Elementen steht, die aus Seltenerdelementen ausgewählt werden, die sich von La und den Elementen M unterscheiden,
in den Formeln [III] und [IV],
w2 für eine Herstellungsmenge des Elements La steht, wenn ein Molverhältnis von Si 6 ist; und
x2 für eine Herstellungsmenge des Elements A steht, wenn ein Molverhältnis von Si 6 ist,
wobei die Herstellungsmengen so eingestellt werden, dass eine Zusammensetzung von Metallelementen, die in den Rohmaterialien enthalten sind, eine Zusammensetzung der folgenden Formel (2) erfüllt:

$$La_{w2}A_{x2}Si_6N_{y2}M_{z2} \qquad (2)$$

wobei in der Formel (2),

das Element M für eines oder mehrere von Elementen steht, die aus Eu, Ce, Mn, Fe und Pr ausgewählt werden;
das Element A für eines oder mehrere von Elementen steht, die aus Seltenerdelementen ausgewählt werden, die sich von La und den Elementen M unterscheiden,
w2 ein Wert ist, der den Ausdruck [IV] erfüllt,

x2, y2 und z2 jeweils unabhängig voneinander für Werte stehen, die die folgenden Formeln erfüllen:

x2 erfüllt $0,2 \leq x2 \leq 1,5$,
y2 erfüllt $8,0 \leq y2 \leq 14,0$, und
z2 erfüllt $0,05 \leq z2 \leq 1,0$.

**Revendications**

1. Phosphore comprenant,
une phase cristalline tétragonale,
dans lequel la phase cristalline présente une composition représentée par la formule suivante (1) :

$$La_wA_xSi_6N_yM_z \qquad (1)$$

dans lequel dans la formule (1),
un élément M représente un ou plusieurs des éléments choisis parmi Eu, Ce, Mn, Fe et Pr,
un élément A représente un ou plusieurs des éléments choisis parmi des éléments de terres rares autres que La, Eu, Ce, Mn, Fe et Pr,
w, x, y et z représentent chacun indépendamment des valeurs satisfaisant les formules suivantes :

w satisfait $1,50 \leq w \leq 2,7$,
x satisfait $0,2 \leq x \leq 1,5$
y satisfait $8,0 \leq y \leq 14,0$, et
z satisfait $0,05 \leq z \leq 1,0$,

dans lequel la phase cristalline satisfait la formule suivante [I] et [II] :

$$0,10 \leq x/(w+x) \leq 0,50 \qquad [I]$$

$$2,80 \leq w+x+z \leq 3,20 \qquad [II]$$

dans lequel dans des formules [I] et [II]

w représente une teneur d'un élément La lorsqu'un rapport molaire de Si est 6 ;
x représente une teneur d'un élément A lorsqu'un rapport molaire de Si est 6 ; et
z représente une teneur d'un élément M lorsqu'un rapport molaire de Si est 6,

dans lequel une constante de réseau a est 1,0104 nm (10,104 Å) ou plus et 1,0154 nm (10,154 Å) ou moins.

2. Phosphore comprenant,
une phase cristalline tétragonale,
dans lequel la phase cristalline présente une composition représentée par la formule suivante (1) :

$$La_wA_xSi_6N_yM_z \qquad (1)$$

dans lequel dans la formule (1),

un élément M représente un ou plusieurs des éléments choisis parmi Eu, Ce, Mn, Fe et Pr,
un élément A représente un ou plusieurs des éléments choisis parmi des éléments de terres rares autres que La, Eu, Ce, Mn, Fe et Pr,
w, x, y et z représentent chacun indépendamment des valeurs satisfaisant les formules suivantes :

w satisfait $1,50 \leq w \leq 2,7$,
x satisfait $0,2 \leq x \leq 1,5$
y satisfait $8,0 \leq y \leq 14,0$, et

z satisfait $0,05 \leq z \leq 1,0$,

dans lequel une constante de réseau a est 1,0104 nm (10,104 Å) ou plus et 1,0154 nm (10,154 Å) ou moins, dans lequel le phosphore est obtenu en préparant des matières premières de sorte qu'un rapport de chaque élément inclus dans les matières premières satisfait les formules suivantes [III] et [IV] et en allumant les matières premières :

$$0,1 \leq x2/(w2 + x2) \leq 0,5 \qquad [III]$$

$$2,85 \leq w2 \leq 3,2 \qquad [IV]$$

dans lequel

w2 représente une quantité de préparation d'un élément La lorsqu'un rapport molaire de Si est 6 ; et x2 représente une quantité de préparation d'un élément A lorsqu'un rapport molaire de Si est 6.

3. Phosphore selon la revendication 1 ou 2,
dans lequel le phosphore présente une longueur d'onde de pic d'émission dans une plage de 546 nm ou plus et 570 nm ou moins par irradiation avec une lumière d'excitation présentant une longueur d'onde de 300 nm ou plus et 460 nm ou moins.

4. Dispositif d'émission de lumière comprenant :

un premier illuminant ; et
un second illuminant qui émet une lumière visible par irradiation avec une lumière provenant du premier illuminant,
dans lequel le second illuminant inclut un ou plusieurs phosphores de nitrure selon l'une quelconque des revendications 1 à 3 en tant qu'un premier phosphore.

5. Appareil d'illumination comprenant :
le dispositif d'émission de lumière selon la revendication 4 en tant qu'une source de lumière.

6. Appareil d'affichage d'image comprenant :
le dispositif d'émission de lumière selon la revendication 4 en tant qu'une source de lumière.

7. Procédé de production d'un phosphore incluant une phase cristalline incluant un élément M, La, un élément A, Si et N, et présentant une constante de réseau a de 1,0104 nm (10,104 Å) ou plus et 1,0154 nm (10,154 Å) ou moins, qui comprend :
la préparation d'une source M, une source La, une source A, et une source Si en tant que matières premières de sorte qu'un rapport de chaque élément satisfait les formules suivantes [III] et [IV] et l'allumage des matières premières :

$$0,1 \leq x2/(w2 + x2) \leq 0,5 \qquad [III]$$

$$2,85 \leq w2 \leq 3,2 \qquad [IV]$$

dans lequel un élément M représente un ou plusieurs des éléments choisis parmi Eu, Ce, Mn, Fe et Pr ; et un élément A représente un ou plusieurs des éléments choisis parmi des éléments de terres rares autres que La et les éléments M,

dans les formules [III] et [IV],

w2 représente une quantité de préparation d'un élément La lorsqu'un rapport molaire de Si est 6 ; et x2 représente une quantité de préparation d'un élément A lorsqu'un rapport molaire est 6,

dans lequel des quantités de préparation sont ajustées de sorte qu'une composition d'éléments métalliques inclus dans les matières premières satisfait une composition représentée par la formule suivante (2) :

$$La_{w2}A_{x2}Si_6N_{z2} \qquad (2)$$

dans lequel dans la formule (2),

un élément M représente un ou plusieurs des éléments choisis parmi Eu, Ce, Mn, Fe et Pr ;
un élément A représente un ou plusieurs des éléments choisis à partir d'éléments de terres rares autres que La et les éléments M,
w2 est une valeur satisfaisant l'expression [IV],
x2, y2 et z2 représentent chacun indépendamment des valeurs satisfaisant les formules suivantes :

x2 satisfait $0{,}2 \leq x2 \leq 1{,}5$ ;
y2 satisfait $8{,}0 \leq y2 \leq 14{,}0$ ; et
z2 satisfait $0{,}05 \leq z2 \leq 1{,}0$.

FIG. 1

FIG. 2

FIG. 3

FIG. 4

FIG. 5

FIG. 6

FIG. 7

FIG. 8

FIG. 9

FIG. 10

FIG. 11

FIG. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008132954 A
- WO 2010114061 A
- WO 2014123198 A
- JP 2008502131 T
- WO 2009154193 A
- JP 2009091546 A
- JP 2016028124 A
- US 2014319568 A1
- JP 2007291352 A